# EUROPEAN PATENT APPLICATION

(11) **EP 0 665 307 A2**
(43) Date of publication of application: **02.08.1995**
(21) Application number: 95300295.3
(22) Date of filing: 18.01.1995
(51) Int. Cl.: C23C 16/50

(54) **Film forming CVD-apparatus and method effected by the same**

(30) Priority: 27.01.1994 JP 7895/94
(71) Applicant: CANON SALES CO., INC., Minato-ku, Tokyo (JP); ALCAN-TECH CO., INC., Tokyo 108 (JP); SEMICONDUCTOR PROCESS LABORATORY CO., LTD., Minato-ku, Tokyo 108 (JP)
(72) Inventor: Maeda, Kazuo, c/o Semicon. Pro. Lab. Co. Ltd., Tokyo (JP); Ohira, Kouichi, c/o Semicon. Pro. Lab. Co. Ltd., Tokyo (JP); Nishimoto, Yuhko, c/o Semicon. Pro. Lab. Co. Ltd., Tokyo (JP)
(74) Representative: Maury, Richard Philip

(57) **Abstract**

A plasma generating chamber (1) and a film forming chamber (7) are provided with a film forming apparatus of the present invention. A first reaction gas is introduced into the plasma generating chamber (1) to be plasmanized, and a second reaction gas is introduced into the film forming chamber (7). A wafer (15) on which a film is grown is placed in the lower part of the film forming chamber (7) while being biased by a voltage. The second reaction gas which is introduced into the film forming chamber (7) is activated by the first reaction gas in plasma state and is deposited on the wafer by virtue of a chemical reaction to thus form the film on the wafer.

## Description

### Background of the Invention

### 1. Field of the Invention

The present invention relates to a film forming apparatus and a method effected by the same and, more particularly, a film forming apparatus for forming an insulating film etc. by means of a chemical vapor deposition (CVD) method to activate reaction gas by plasmanizing it and a method effected by the same.

### 2. Description of the Related Art

Upon manufacturing semiconductor devices, the CVD method is an available technique when Si0₂ film, PSG film, BSG film, BPSG film, Si₃N₄ film, non- crystalline Si film, polycrystalline Si film, W film, Mo film, WSi₂ film, AI film and the like are formed.

If conventional CVD methods are classified based on a means for activating the reaction gas, three main methods are raised as follows:
1) Thermal CVD method,
2) Photo CVD method, and
3) Plasma CVD method.

The thermal CVD method uses a method of activating the reaction gas by the temperature, and is classified into a low pressure type and a normal pressure type according to the used pressure. It is also classified into a low temperature type and a high temperature type. It is further classified into a resistance heating type, an induction heating type, and a lamp heating type according to the heating method. In addition, it is classified into a hot wall type and a cold wall type according to the location of the heating means.

The photo CVD method uses a method of activating the reaction gas by irradiating ultraviolet rays to the reaction gas so as to supply energy to the reaction gas. It can form the film under low or high pressure and at a low temperature.

The plasma CVD method uses a method of activating the reaction gas directly or indirectly using alternating electric power and a magnetic field. In general, it is executed under low pressure and at a low temperature. Based on a plasma generating means, it is classified into a parallel plate type where the reaction gas is activated directly by irradiating high frequency electric power, and an Electron Cyclotron Resonance (ECR) method type where electrons are energized by the high frequency electric power and the magnetic field, and then the reaction gas is activated indirectly by the electrons.

The above thermal CVD method is not suitable for some cases since the substrate becomes a high temperature. Further, it has still some room for improvement in respect of film quality such as fineness.

In the photo CVD method, the film is formed in unnecessary area so that particles etc. are generated. Further, the deposition rate is slow, and there is some room for improvement in practical use.

The plasma CVD method, especially the parallel plate type plasma CVD method, causes damage to the substrate by the plasma irradiation. Thus, in case such damage to the substrate must be particularly taken into consideration, the plasma CVD method using the ECR method may be used. In this case, the ECR method is effective in preventing the damage of the substrate and forming the fine film, but the apparatus must be constituted on a large scale since it needs ultra-high frequency of the frequency 2.45 GHz.

### Summary of the Invention

The present invention has been made for the purpose of overcoming the drawbacks in the conventional CVD methods.

It is therefore the first object of the present invention to provide a film forming apparatus which is capable of forming an insulating film having excellent film quality and has a simple structure.

It is the second object of the present invention to provide a film forming method which is capable of forming an insulating film having excellentfilm quality by means of the film forming apparatus.

The film forming apparatus according to the present invention comprises an external antenna for irradiating electromagnetic waves, for example, high frequency electric power of the frequency 13.56 MHz, into a plasma generating chamber, and an external source solenoid for forming magnetic field in the plasma generating chamber, whereby high density plasma can be generated in a helicon mode in the plasma generating chamber. In this case, using the high frequency electric power of the relatively low frequency such as the frequency 13.56 MHz, which is applied to the antenna, such high density plasma can be generated. Therefore, an equipment such as a waveguide for generating microwave electric power of the extremely high frequency 2.45 GHz as in the ECR method can be omitted and an arrangement of the apparatus can be simplified.

Apart from the first reaction gas introducing pipe for introducing the first reaction gas serving as the plasma in the helicon mode into the plasma generating chamber, the second reaction gas introducing pipe for discharging the second reaction gas is arranged over the surface of the substrate. As a result, the reaction gas can be prevented from reacting while it is introduced to the surface of the substrate, and therefore generation of particles can be prevented.

Further, since a high frequency power source for supplying high frequency electric power of the frequency 13.56 MHz or 100 kHz is connected to a substrate holder, film quality such as film density and stress can be optimized by adjusting negative DC voltage applied to the substrate.

In the film forming method according to the present invention, plasma in the helicon mode is generated from the first reaction gas, for example, the oxygen (0₂) gas, by irradiating electromagnetic wave of the frequency 13.56 MHz and applying a magnetic field thereto. The second reaction gas, for example, TEOS or monosilane (SiH₄) gas is then activated by the plasma transferred to the downstream. The film is then formed on the substrate by causing the first reaction gas and the second reaction gas to react to each other.

Since the plasma in the helicon mode can be generated in higher density (1 X 10¹² cm-³) than the plasma formed by the ECR method, fineness of the formed film is improved still more, like the film quality of the thermal oxide film.

Besides, since the substrate is biased by the voltage, density and stress of the film formed on the substrate can be optimized.

Especially, if the plasma in the helicon mode generated by the oxygen gas and the monosilane is used, it has been confirmed from the experience that, in order to improve the film quality of the formed film, it is preferable to bias the substrate by the voltage, i.e., to apply the high frequency electric power of the frequency 100 kHz to the substrate.

Furthermore, the plasma of the first reaction gas is transferred to the downstream, and the second reaction gas discharged immediately before the substrate on which the film is formed is activated thereby. Thereafter the first reaction gas and the second reaction gas are caused to react to each other. Therefore, most of the reaction products are deposited on the surface of the substrate. As a result, the reaction product can be prevented from being deposited on the inner wall of the reaction chamber near the substrate, and thus generation of particles can be prevented.

### Brief Description of the Drawings

Fig. 1 is a diagram showing a structure of a CVD film forming apparatus used in a film forming method using the plasma in the helicon mode according to an embodiment of the present invention;
Fig. 2 is a perspective view showing a detailed structure of an external antenna in the CVD film forming apparatus using the plasma in the helicon mode according to the embodiment of the present invention;
Fig. 3 is a characteristic diagram showing the relation between the magnetic field and the source solenoid electric current in the CVD film forming apparatus using the plasma in the helicon mode according to the first embodiment of the film forming method of the present invention;
Figs. 4a to 4d are characteristic diagrams each illustrating a deposition rate of the silicon oxide film formed by the CVD method using the plasma in the helicon mode according to the first embodiment of the film forming method of the present invention;
Figs. 5a to 5d are characteristic diagrams each illustrating a deposition rate of the silicon oxide film formed by the CVD method using the plasma in the helicon mode according to the first embodiment of the film forming method of the present invention;
Figs. 6a to 6d are characteristic diagrams each illustrating examination results of an etching rate of the silicon oxide film formed by the CVD method using the plasma in the helicon mode according to the first embodiment of the film forming method of the present invention;
Figs. 7a to 7d are characteristic diagrams each illustrating examination results of an etching rate of the silicon oxide film formed by the CVD method using the plasma in the helicon mode according to the first embodiment of the film forming method of the present invention;
Figs. 8a to 8d are characteristic diagrams each illustrating examination results of stress of the silicon oxide film formed by the CVD method using the plasma in the helicon mode according to the first embodiment of the film forming method of the present invention;
Figs. 9a to 9d are characteristic diagrams each illustrating examination results of stress of the silicon oxide film formed by the CVD method using the plasma in the helicon mode according to the first embodiment of the film forming method of the present invention;

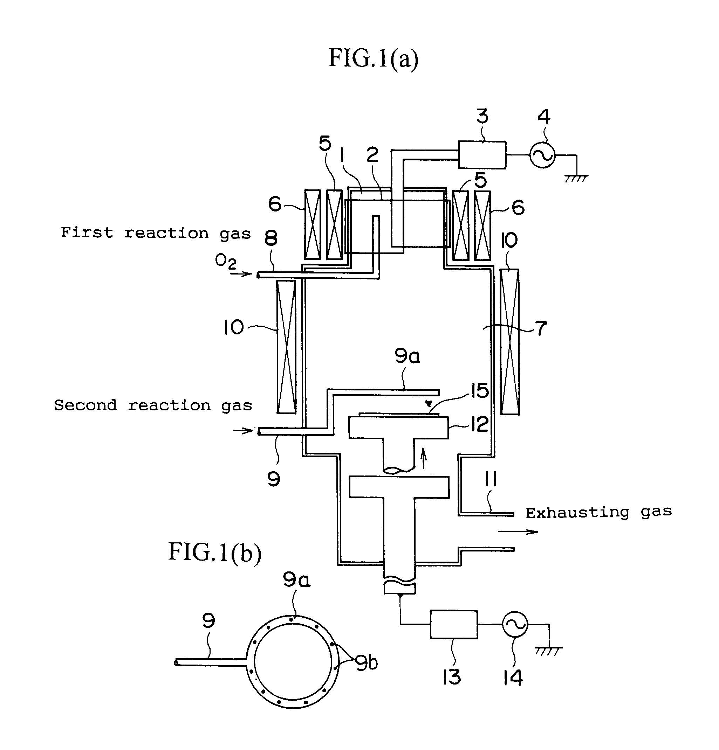

Figs. 1 Oa to 10g are characteristic diagrams each illustrating a deposition rate of the silicon oxide film formed by the CVD method using the plasma in the helicon mode according to the second embodiment of the film forming method of the present invention;

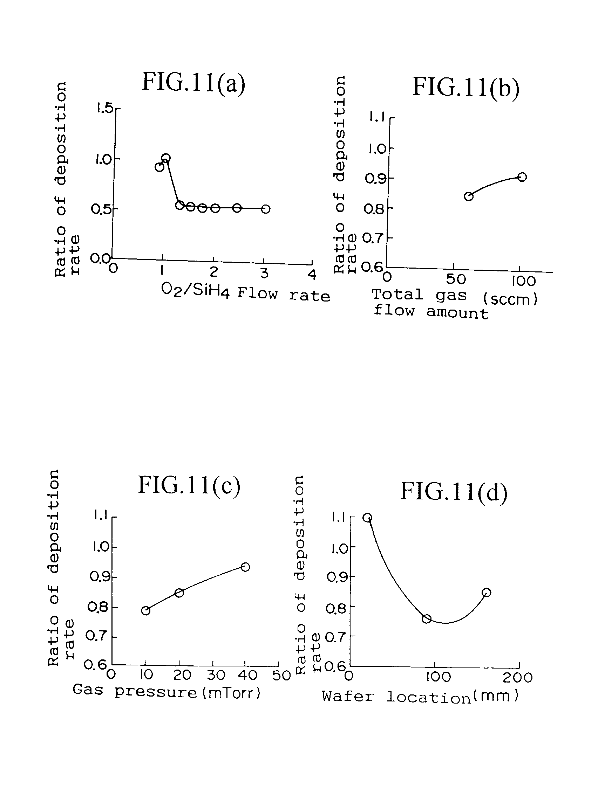

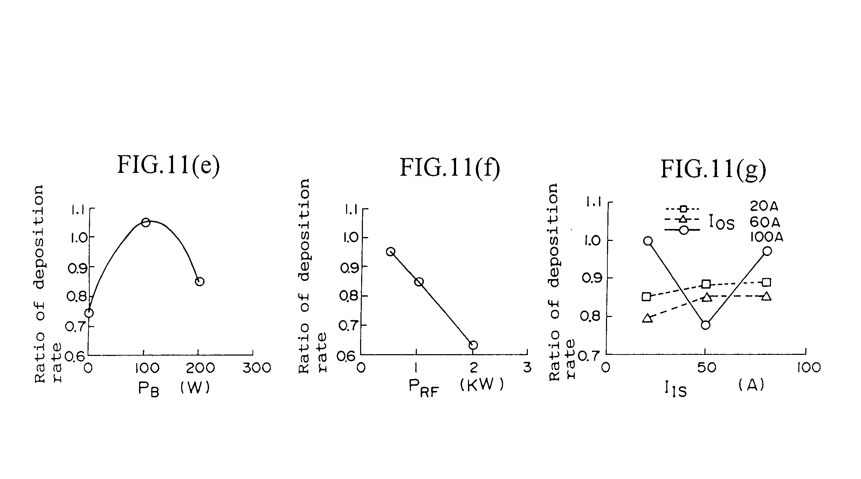

Figs. 11a to 11g are characteristic diagrams each illustrating a deposition ratio of the silicon oxide film formed by the CVD method using the plasma in the helicon mode according to the second embodiment of the film forming method of the present invention;

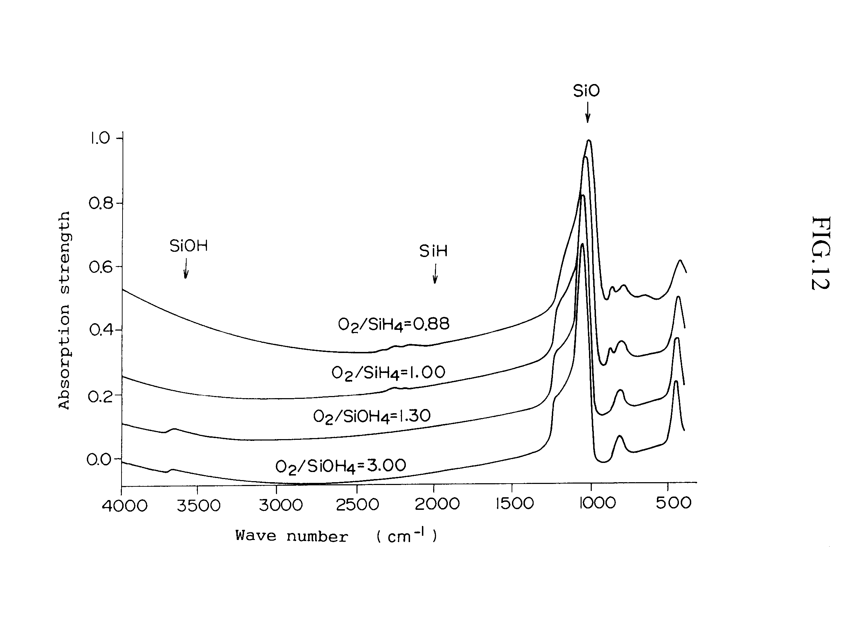

Fig. 12 is a characteristic diagram illustrating an examination result of a deposition rate of the silicon oxide film formed by the CVD method using the plasma in the helicon mode according to the second embodiment of the film forming method of the present invention;

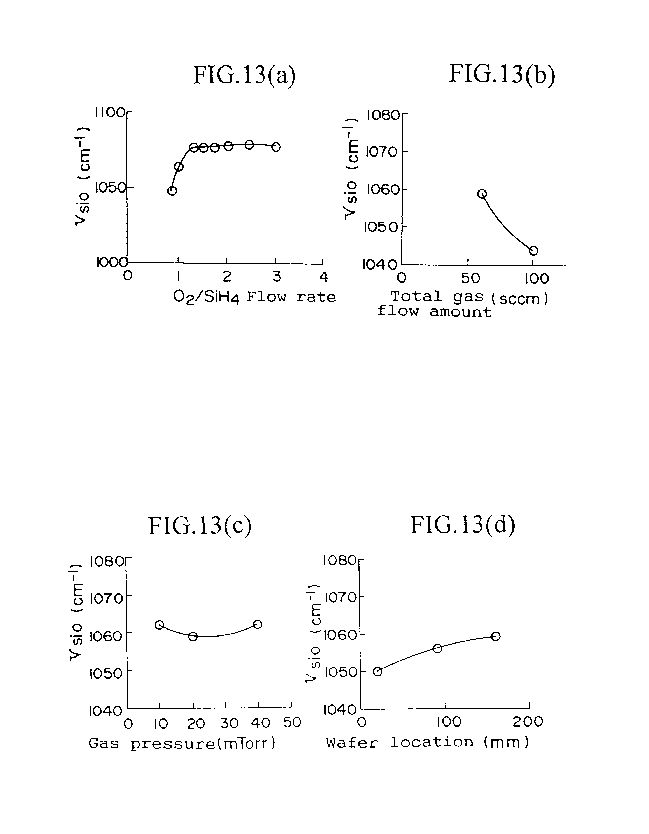

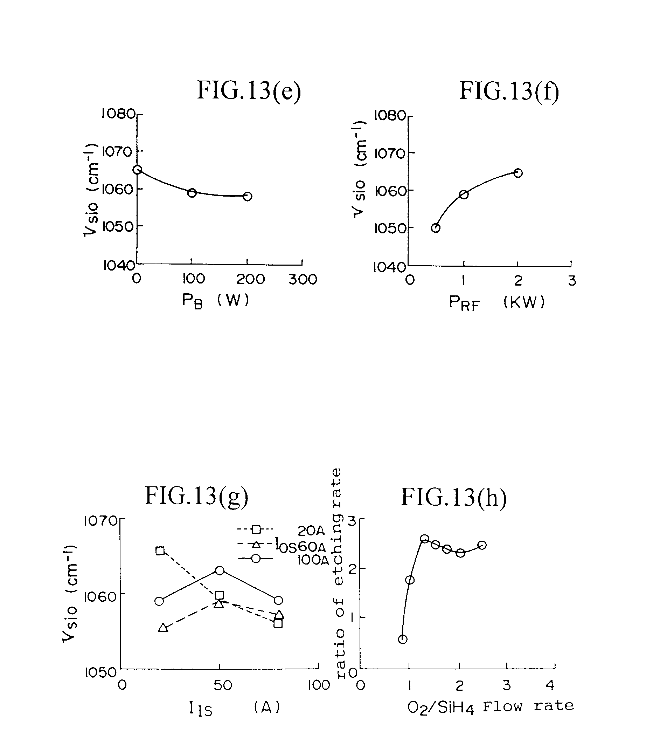

Figs. 13a to 13h are characteristic diagrams each illustrating examination results of an SiO peak wave number ν_{s o} and a ratio of an etching rate of the silicon oxide film formed by the CVD method using the plasma in the helicon mode according to the second embodiment of the film forming method of the present invention;

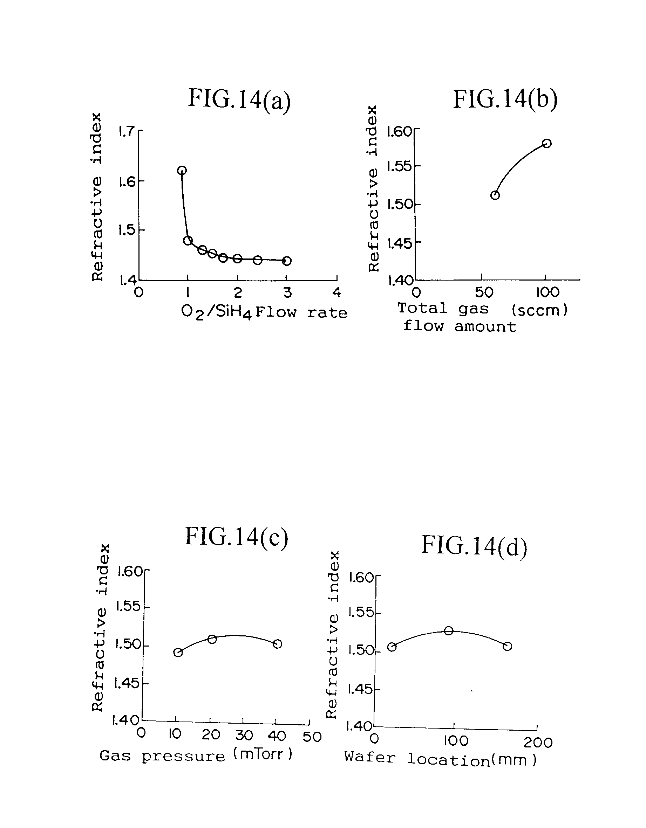

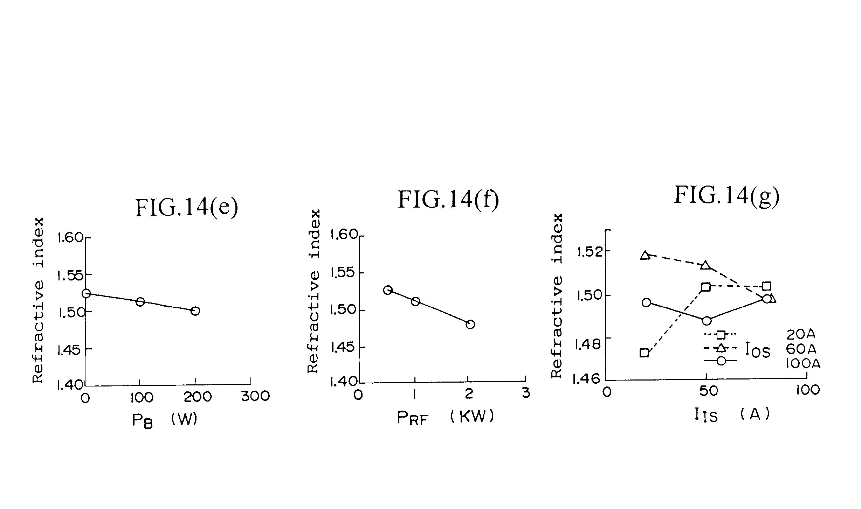

Figs. 14a to 14g are characteristic diagrams each illustrating examination results of a refractive index of the silicon oxide film formed by the CVD method using the plasma in the helicon mode according to the second embodiment of the film forming method of the present invention;

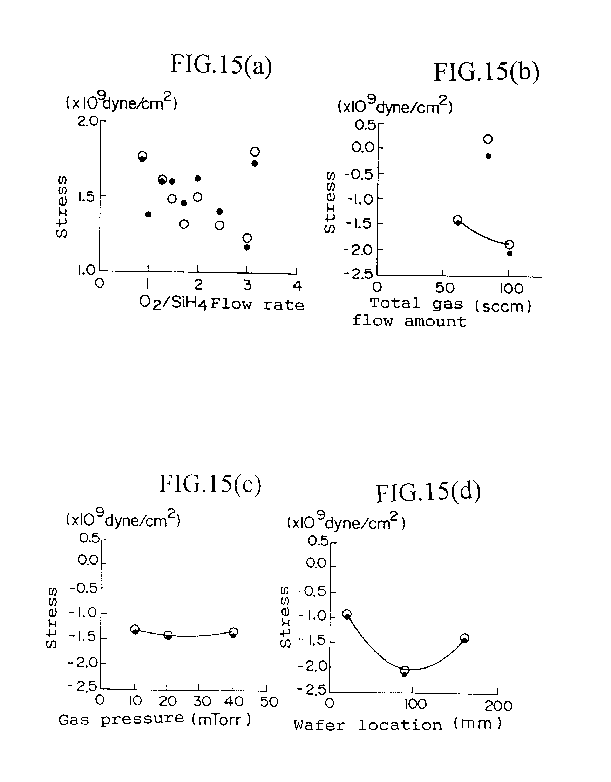

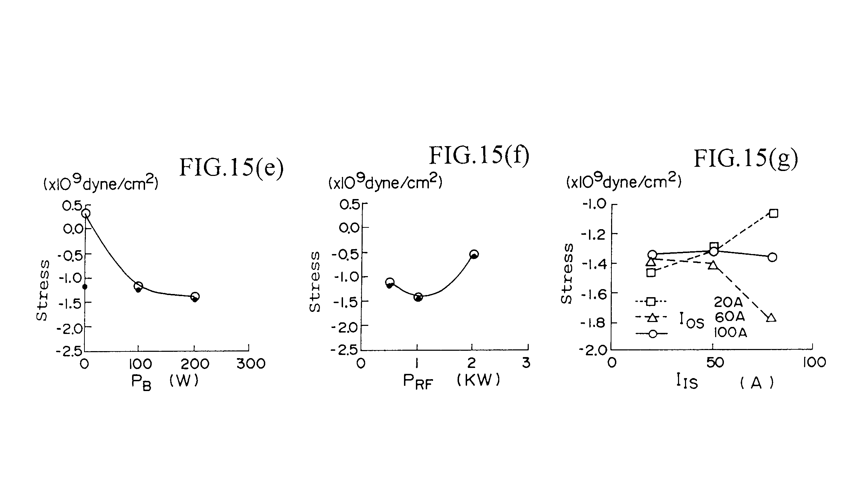

Figs. 15a to 15g are characteristic diagrams each illustrating examination results of stress of the silicon oxide film formed by the CVD method using the plasma in the helicon mode according to the second embodiment of the film forming method of the present invention;

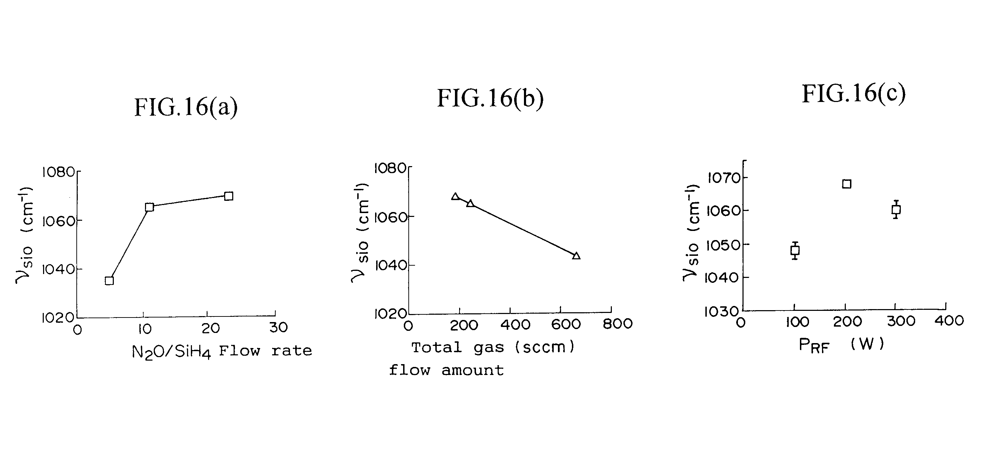

Figs. 16a to 16c are characteristic diagrams each illustrating examination results of an SiO peak wave number ν_{s o} in the silicon containing insulating film formed by the parallel plate type plasma CVD method according to comparison examples;

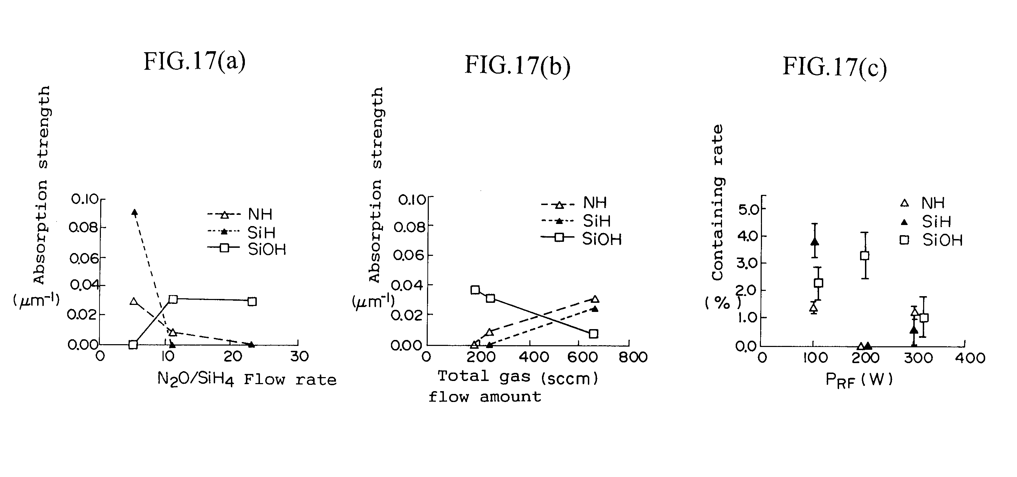

Figs. 17a to 17c are characteristic diagrams each illustrating examination results of an amount of containing SiOH bond, SiH bond and NH bond in the silicon containing insulating film formed by the parallel plate type plasma CVD method according to comparison examples;

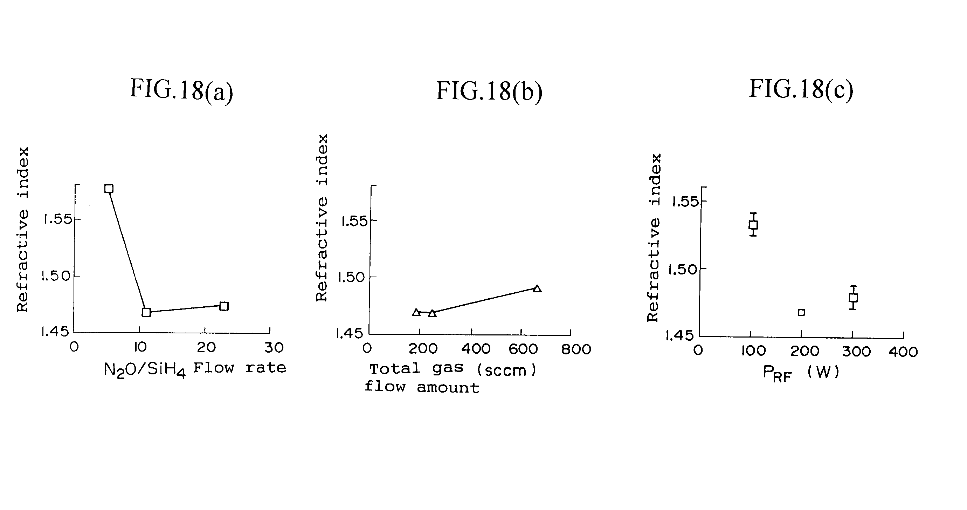

Figs. 18a to 18c are characteristic diagrams each illustrating examination results of a refractive index of the silicon oxide film formed by the parallel plate type plasma CVD method according to comparison examples; and

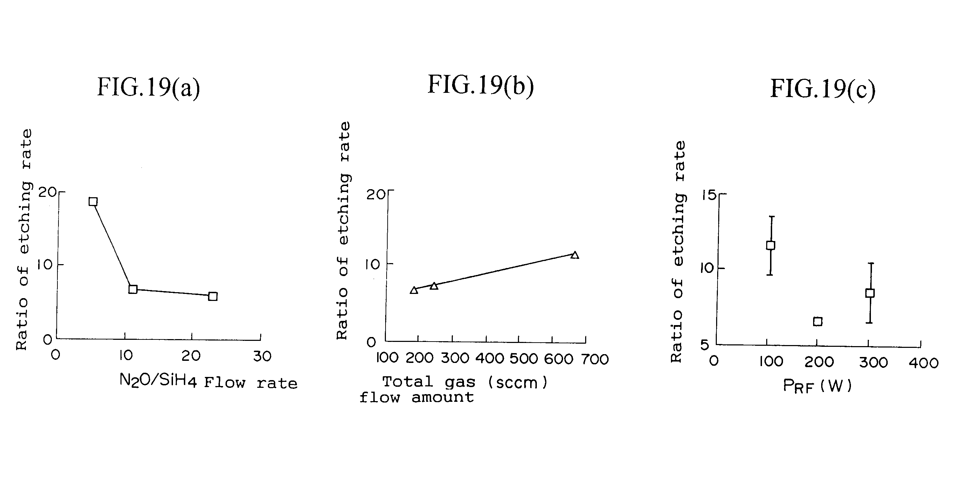

Figs. 19a to 19c are characteristic diagrams each illustrating examination results of an etching rate of the silicon oxide film formed by the parallel plate type plasma CVD method according to comparison examples.

### Detailed Description of the Preferred Embodiments

Preferred embodiments of the present invention will now be described hereinafter with reference to the accompanying drawings.

(1) Explanation of the CVD film forming apparatus used for a film forming method according to an embodiment of the present invention:

Fig.1(a) is a diagram showing a structure of the CVD film forming apparatus used for the film forming method using the plasma in the helicon mode according to the embodiment of the present invention.

In Fig.1(a), a reference 1 denotes a plasma generating chamber made of a silica tube having diameter 15 cm X length 25 cm. The chamber activates the first reaction gas, for example, the oxygen gas (0₂ gas), introduced via the first reaction gas introducing pipe 8. The introducing pipe 8 is disposed so that a gas discharging port of the introducing pipe 8 is placed in the central portion of the plasma generating chamber 1. Note that the introducing pipe 8 can be connected to the upper portion of the plasma generating chamber 1 to introduce the reaction gas into the plasma generating chamber 1.

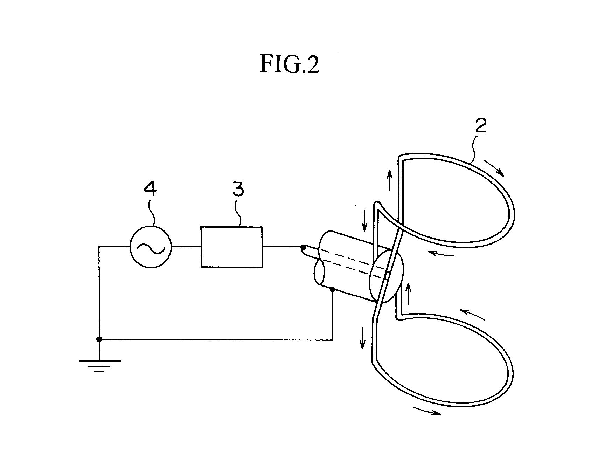

A reference 2 denotes an external antenna attached to the circumference of the plasma generating chamber 1. Two ring conducting wires are arranged to surround the upper and lower circumferences of the cylindrical plasma generating chamber 1 at a predetermined distance. The distance between two ring conducting wires is important to adjust the wave num- berof helicon waves, i.e., to adjust plasma density. An example of a configuration of the external antenna 2 is shown in Fig.2. In this case, an RF electric current flows in each of two ring conducting wires in reverse direction, so that the helicon waves are generated in zero mode. Although not shown in Fig.2, the plasma generating chamber 1 is inserted into two ring conducting wires. Areference 2a denotes an electrode for supplying an electric current to each of ring conducting wires in reverse direction. By changing the configuration of the external antenna 2, the helicon waves can be formed in a high order mode.

In Fig.1, a reference 3 denotes a matching network connected to the external antenna 2, and a reference 4 denotes an RF power source for supplying RF electric power of the frequency 13.56 MHz to the external antenna 2 via the matching network 3. The RF electric power is used as energy to generate the plasma.

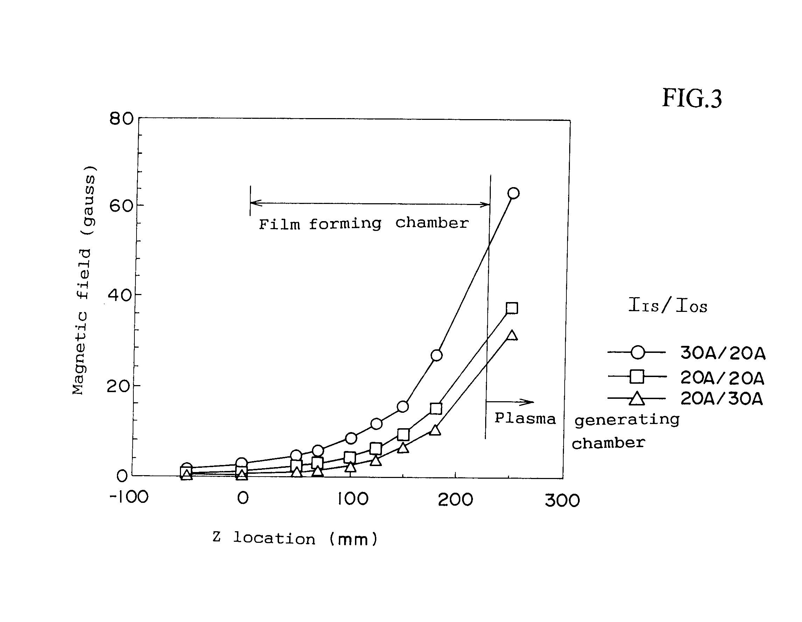

A reference 5 denotes an inner cylindrical source solenoid arranged around the plasma generating chamber 1. A reference 6 denotes an outer cylindrical source solenoid arranged around the inner cylindrical source solenoid 5. Both the innerand outer cylindrical source solenoids 5 and 6 form the magnetic field in the axis direction of the plasma generating chamber 1. Such magnetic field is required to form the helicon waves and to adjust plasma density. Relations between the electric currents flowing in the inner cylindrical source solenoid 5 and the outer cylindrical source solenoid 6 and the generated magnetic fields is shown in Fig.3. In Fig.3, lᵢₛ represents an electric current flowing in the inner cylindrical source solenoid 5, and lₒₛ represents an electric current flowing in the outer cylindrical source solenoid 6. Also, Z location represents a distance in the axis direction, i.e., height direction of the cylindrical film generating chamber 7 starting from the bottom of the chamber 7 as described later.

With the above, the plasma generating chamber 1 and its peripheral portions which are required to generate high density plasma (more than 10¹² cm-³) in the helicon mode are described. Especially, the RF electric power, the magnetic field, and the distance between two ring conducting wires of the external antenna 2 are important parameters.

A reference 7 denotes a film forming chamber which is coupled to the downstream of the plasma generating chamber 1 and is formed of a silica tube or cylindrical metal such as aluminum having the diameter 30 cm X the length 22.5 cm. The plasma in the hel icon mode, wh ich is formed of the first reaction gas generated in the plasma generating chamber 1, is supplied to the chamber 7. Also the second reaction gas, for example, SiH gas, is introduced via the second reaction gas introducing pipe 9 into the chamber 7.

As shown in Fig.1 (b), the second reaction gas introducing pipe 9 has a gas discharging portion 9a made of a ring silica pipe having the diameter of about 20 cm. A plurality of gas discharging holes 9b are formed in the silica pipe of the discharging portion 9a to discharge the reaction gas to the wafer 15. The discharging portion 9a is displaced over the wafer 15 at a predetermined distance.

A reference 10 denotes a chamber solenoid which is provided around the film forming chamber 7 and is made of a cylindrical permanent magnetic. The chamber solenoid 10 applies appropriate magnetic field to the film forming chamber 7. The solenoid 10 causes the plasma to flow from the plasma generating chamber 1 to the film forming chamber 7 and also adjusts a shape of the flowing plasma.

A reference 11 denotes an exhausting port to which an exhausting apparatus is connected so as to exhaust unnecessary reaction gas and to reduce the pressure in the plasma generating chamber 1 and the film forming chamber 7. The exhausting port 11 is formed in the film forming chamber 7.

A reference 12 denotes a wafer holder (substrate retainer) for holding the wafer 15 thereon. The holder 12 has a built-in heater for heating the wafer 15 and can be slid in the axial direction. An RF power source 14 is connected to the wafer holder 12 via the matching network 13 to supply the electric power of the frequency 13.56 MHz or 100 kHz. By applying the electric power of the frequency 13.56 MHz or 100 kHz to the wafer 15, a negative self-bias DC voltage is applied to the wafer 15 to optimize the quality of the formed film such as density, stress etc..

In the next, an operation of the above CVD apparatus will be explained briefly.

First, the oxygen gas is introduced into the plasma generating chamber 1 under the reduced pressure. The electric power of the frequency 13.56 MHz is supplied from the RF power source 4 to the external antenna 2 through the matching network 3. Thereby, RF electric currents are caused to flow through each of two ring conducting wires of the external antenna 2 so as to surround the plasma generating chamber 1 in the reverse direction. Thus the electromagnetic waves are radiated. Further, by supplying the electric current to the inner source solenoid 5 and the outer source solenoid 6, the magnetic field is generated in the axial direction.

Thus the helicon waves are excited, the oxygen gas is activated in the plasma generating chamber 1, and the plasma in the helicon mode having high density (more than 1012 cm-³) can be generated.

The plasma so generated is transferred to the film forming chamber 7, located in the downstream and underthe reduced pressure, by virtue of the magnetic field to activate the SiH₄ gas supplied over the wafer 15. As a result, the activated SiH₄ gas is reacted to the oxygen plasma so that the silicon oxide film is deposited on the wafer 15.

According to the above CVD apparatus, the plasma are generated by supplying the RF electric power of the frequency 13.56 MHz to the external antenna 2 to which the RF power source 4 etc. are connected. Accordingly, the equipment such as the waveguide required for the ECR method is not needed, and thus the configuration becomes simple. Also, since the frequency which is lower than the frequency 2.45 GHz used in the ECR method can be used, it is easy to generate the high frequency electric power.

Besides, since the first reaction gas introducing pipe 8 for the oxygen gas and the second reaction gas introducing pipe 9 for the SiH₄ gas are arranged separately, the reaction between the reaction gases can be prevented while they are supplied. Thus generation of particles can be prevented. However, it is noted that all gases can be introduced through the first reaction gas introducing pipe 8 as the case may be.

Dimensions of the plasma generating chamber 1 and the film forming chamber 7 can be changed appropriately.

(2) Explanation of the film forming method by the CVD method using the plasma in the helicon mode according to an embodiment of the present invention:
(A) Explanation of an embodiment according to the first film forming method
(i) Embodiment according to the first film forming method

Then a film forming method using the CVD film forming apparatus in Fig.1 and according to an embodiment of the first film forming method of the present invention will be described. The 0₂ gas and TEOS (N₂) gas are used as the reaction gas. The TEOS (N₂) gas is derived by effecting a bubbling in the TEOS solution at a room temperature using the N₂ gas as a carrier gas. TEOS is represented by Si(OC₂H₆)₄ (4 ethoxysilane).

Main conditions for forming the film are pointed out as follows:
(a) Ratio of flow rate of 0₂/TEOS(N₂) (standard value=3)
(b) Total gas flow amount (standard value of total gas flow amount=1.75 SLM, standard value of O2 gas flow amount=1.31 SLM, and standard value of TEOS (N₂) gas flow amount=0.44 SLM)
(c) Gas pressure (standard value=0.2 Torr)
(d) Substrate temperature (standard value=350 °C)
(e) Wafer location (Assuming that the lower end of the film forming chamber 7 is regarded as zero, the location upper zero is set as a positive side, and the location below zero is set as a negative side. standard value=+45 mm)
(f) RF electric power applied to the external antenna 2 [P_{RF]} (standard value=1.5 kW)
(g) Inner source solenoid electric current [l_{is]} (standard value=20 A)
(h) Outer source solenoid electric current [l_{os]} (standard value=60 A)

In this embodiment, in order to examine characteristics of the formed film, various samples have been prepared, with changing each parameter. The above standard values denote fixed values of other parameters while the concerned parameter is being changed.

First, interiors of the plasma generating chamber 1 and the film forming chamber 7 are exhausted by the turbo molecular pump and are held less than 1 X 1 Ocm-³ Torr.

Subsequently, the wafer holder 12 on which the wafer 15 has been held is moved upwardly, and is then set at a predetermined location in the film forming chamber 7. Then the wafer 15 is heated by the built-in heater (not shown) of the wafer holder 12, and held at a predetermined temperature.

Next, the 0₂ gas of a predetermined amount is introduced into the plasma generating chamber 1 via the first reaction gas introducing pipe 8, and the TEOS (N₂) gas of a predetermined amount is introduced into the film forming chamber 7 via the second reaction gas introducing pipe 9. Subsequently, the gas pressure in the film forming chamber 7 is adjusted and held at a predetermined pressure.

The inner source solenoid 5 and the outer source solenoid 6 are energized by respectively flowing a predetermined electric current to generate the magnetic field. Predetermined RF electric power is applied to the external antenna 2 via the matching network 3. As a result, the 0₂ gas is activated and the plasma is generated in the helicon mode. The TEOS gas is then activated by the plasma in a helicon mode which flows into the film forming chamber 7 downwardly. The activated TEOS gas and the oxygen plasma react to each other, and the deposition of the silicon oxide film is commenced on the wafer 15 at a predetermined deposition rate.

While keeping this state for a predetermined time, the silicon oxide film having a predetermined thickness is formed.

(ii) Explanation of examination result of the characteristics of the silicon oxide film according to the embodiment of the first film forming method.

As to the silicon oxide film formed as above, results of a deposition rate of the film, an etching rate of the formed film, and stress of the formed film will be described.

### 1) Deposition rate of the silicon oxide film

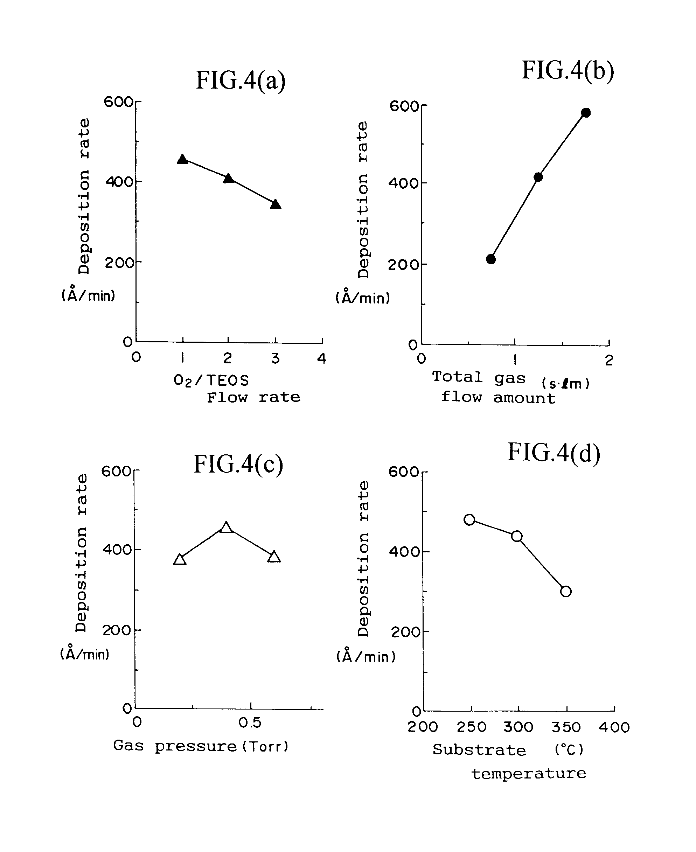

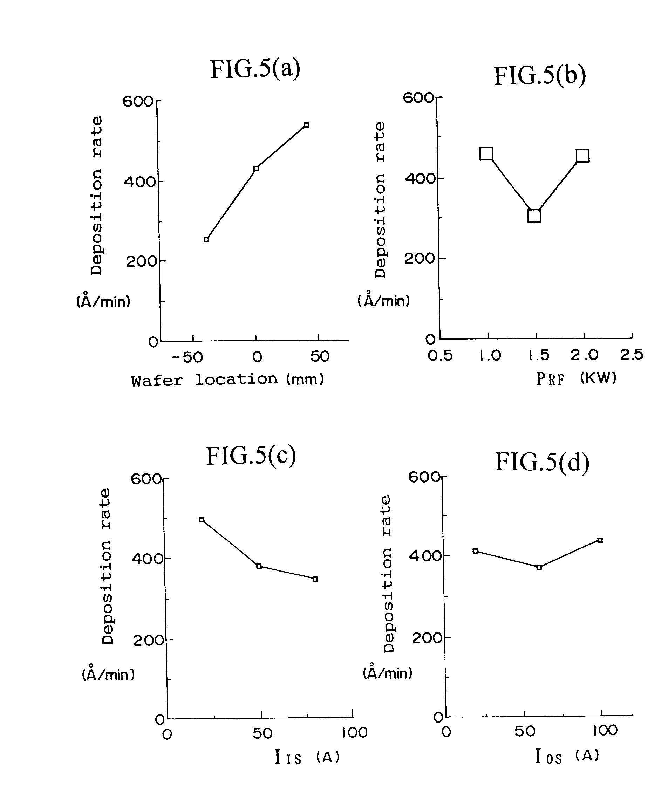

In a predetermined range of each parameter, dependencies of the deposition rate of the silicon oxide film are shown in Figs.4(a) to (d) and Figs.5(a) to (d).

Fig.4(a) is a characteristic diagram showing the dependency of the deposition rate in a range 1 to 3 of the ratio of the flow rate of 0₂/TEOS(N₂). As shown in Fig.4(a), the deposition rate becomes small as the ratio of the flow rate of 0₂/TEOS(N₂) is increased. It changes in a range from 450 A/min to 350 A/min.

Fig.4(b) is a characteristic diagram showing the dependency of the deposition rate in a range 0.75 SLM to 1.75 SLM of the total gas flow amount. As shown in Fig.4(b), the deposition rate becomes large as the total flow amount of 0₂+TEOS(N₂) is increased. It changes in a range from 200 A/min to 600 A_{/}min.

Fig.4(c) is a characteristic diagram showing the dependency of the deposition rate in a range 0.2 Torr to 0.6 Torr of the gas pressure. As shown in Fig.4(c), the deposition rate has the maximum value 460 A/min at the total gas pressure 0.4 Torr of 0₂+TEOS(N₂). It changes in a range from 380 A/min to 460 A/min.

Fig.4(d) is a characteristic diagram showing the dependency of the deposition rate in a range 250 °C to 350 °C of the substrate temperature. As shown in Fig.4(d), the deposition rate becomes small as the substrate temperature is increased. It changes in a range from 500 A/min to 300 A/min.

Fig.5(a) is a characteristic diagram showing the dependency of the deposition rate in a range -45mm to +45 mm of the wafer location. As shown in Fig.5(a), the deposition rate becomes large as the wafer location rises upwardly. It changes in a range from 500 A/min to 300 A/min.

Fig.5(b) is a characteristic diagram showing the dependency of the deposition rate in a range 1 kW to 2 kW of the RF electric power. As shown in Fig.5(b), the deposition rate has the minimum value 300 A/min at the RF electric power 1.5 kW. It changes in a range from 300 A/min to 460 A/min.

Fig.5(c) is a characteristic diagram showing the dependency of the deposition rate in a range 20 A to 80 A of the inner source solenoid electric current. As shown in Fig.5(c), the deposition rate becomes small as the inner source solenoid electric current is increased. It changes in a range from 500 A/min to 300 A_{/}min.

Fig.5(d) is a characteristic diagram showing the dependency of the deposition rate in a range 20 A to 80 A of the outer source solenoid electric current. As shown in Fig.5(d), the deposition rate has the minimum value 380 A/min at the outer source solenoid electric current 60 A. It changes in a range from 380 A/min to 440 A/min.

According to the film forming method of the embodiment of the present invention, when the method of this embodiment is compared with the CVD method using the ECR method, the deposition rate of this embodiment is substantially equal to that of the ECR method although the deposition rate is small. Therefore, there is no inconvenience in practical use.

### 2) Etching rate of the formed film

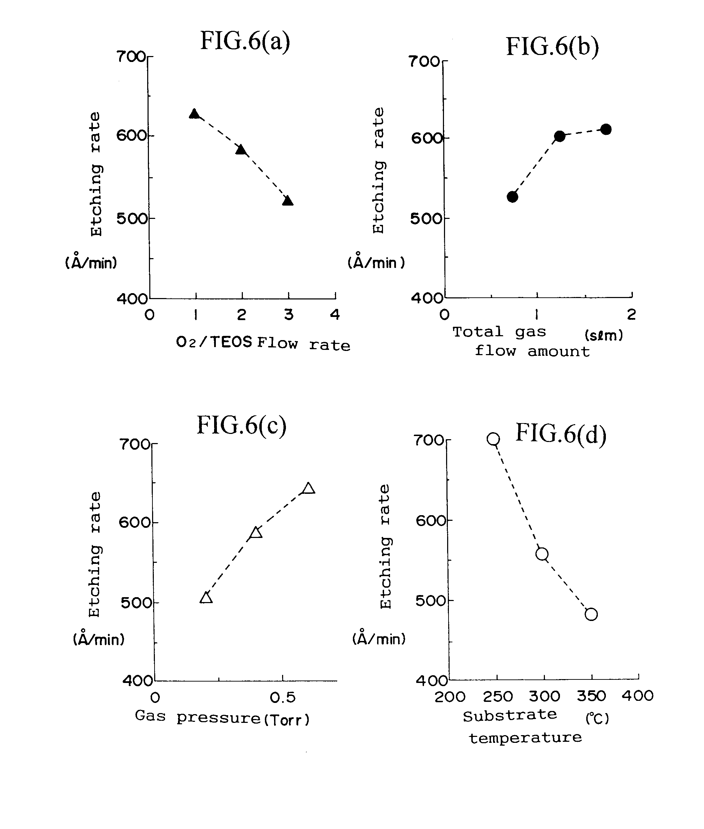

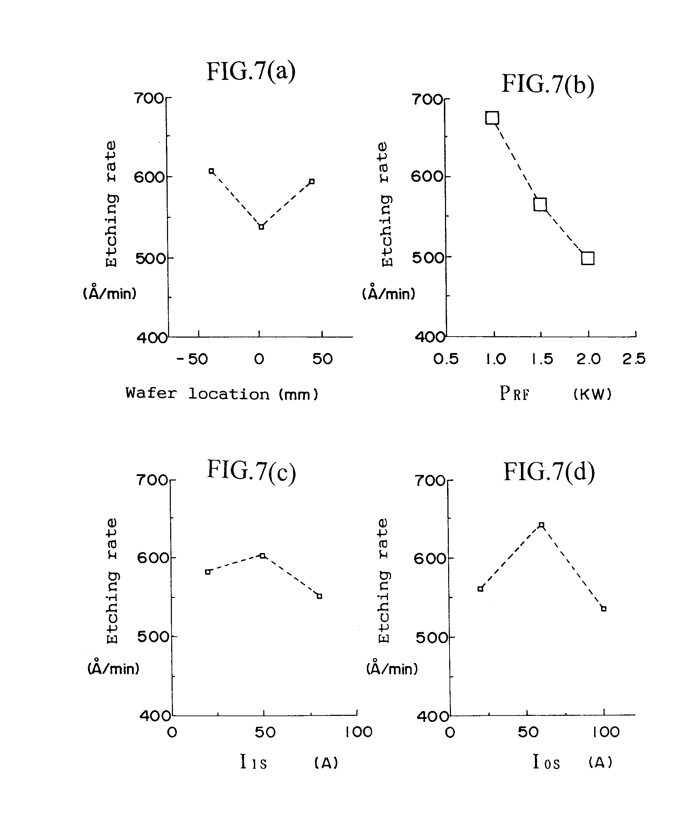

Dependencies of the etching rate of the formed film in a predetermined range of each parameter are shown in Figs.6(a) to (d) and Figs.7(a) to (d).

A measurement of the etching rate has been effected using the 1.2 % HF aqueous solution. The smaller the etching rate becomes, the finer the silicon oxide film becomes. This characteristic is desirable for the insulating film used in the semiconductor device, for example. Now the etching rate of the silicon oxide film formed by the thermal oxidation is 98 A_{/}min.

Fig.6(a) is a characteristic diagram showing the dependency of the etching rate in a range 1 to 3 of the ratio of the flow rate of 0₂/TEOS(N₂). As shown in Fig.6(a), the etching rate becomes small as the ratio of the flow rate of 0₂/TEOS(N₂) is increased. It changes in a range from 625 A/min to 525 A/min.

Fig.6(b) is a characteristic diagram showing the dependency of the etching rate in a range 0.75 SLM to 1.75 SLM of a total gas flow amount. As shown in Fig.6(b), the etching rate becomes large as the total flow amount of 0₂+TEOS(N₂) is increased. It changes in a range from 525 A/min to 610 A/min.

Fig.6(c) is a characteristic diagram showing the dependency of the etching rate in a range 0.2 Torr to 0.6 Torr of a gas pressure. As shown in Fig.6(c), the etching rate becomes large as the total gas pressure of 0₂+TEOS(N₂) is increased. It changes in a range from 500 A/min to 650 A/min.

Fig.6(d) is a characteristic diagram showing the dependency of the etching rate in a range 250 °C to 350 °C of the substrate temperature. As shown in Fig.6(d), the etching rate becomes small as the substrate temperature is increased. It changes in a range from 700 A/min to 480 A/min.

Fig.7(a) is a characteristic diagram showing the dependency of the etching rate in a range -45mm to +45 mm of the wafer location. As shown in Fig.7(a), the etching rate has the minimum value 540 A/min at the wafer location 0 mm. It changes in a range of 540 A/min to 610 A/min.

Fig.7(b) is a characteristic diagram showing the dependency of the etching rate in a range 1 kW to 2 kW ofthe RF electric power. As shown in Fig.7(b), the etching rate becomes small as the RF electric power is increased. It changes in a range from 675 A/min to 500 A/min.

Fig.7(c) is a characteristic diagram showing the dependency of the etching rate in a range 20 A to 80 A of the inner source solenoid electric current. As shown in Fig.7(c), the etching rate has the maximum value 600 A/min at the inner source solenoid electric current 50 A. It changes in a range from 550 A/min to 600 A/min.

Fig.7(d) is a characteristic diagram showing the dependency of the etching rate in a range 20 A to 80 A of the outer source solenoid electric current. As shown in Fig.7(d), the etching rate has the maximum value 640 A/min at the outer source solenoid electric current 60 A, and it changes in a range of 530 A/min to 640 A/min.

As described specifically above, the etching rate of the silicon oxide film formed according to the embodiment of the present invention is compared favorably with that of the silicon oxide film formed by the CVD method using the ECR method. It seems that, as in the same as the CVD method using the ECR method, this is because the film has been formed by using the high density plasma. Judging from the above etching rate, it can be concluded that the film quality is sufficiently good as the insulating film used in the semiconductor device.

### 3) Stress of the formed film

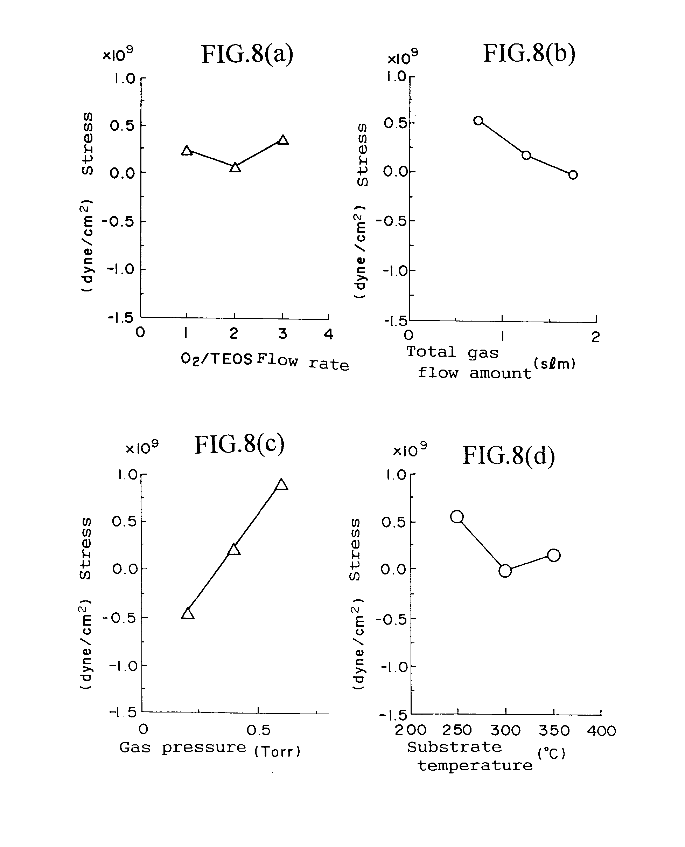

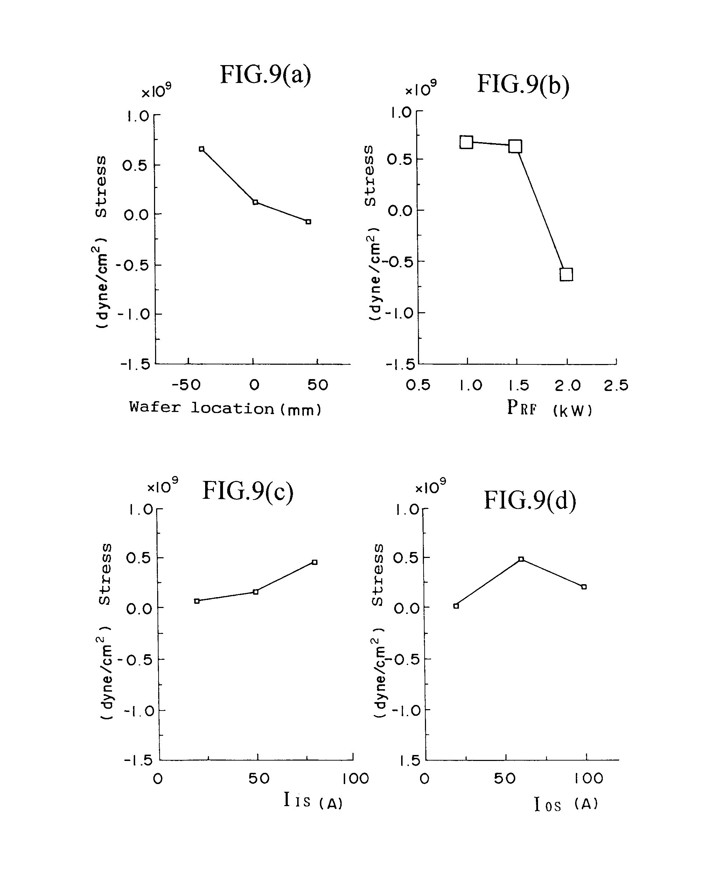

Dependencies of the stress of the formed film in a predetermined range of each parameter are shown in Figs.8(a) to (d) and Figs.9(a) to (d).

A measurement of the stress has been effected by calculating a warping amount of the substrate, like the ordinary case. A positive sign represents a tensile stress, and a negative sign represents a compressive stress.

Fig.8(a) is a characteristic diagram showing the dependency of the stress in a range 1 to 3 of the ratio of the flow rate of 0₂/TEOS(N₂). As shown in Fig.8(a), the stress has the minimum value +0.1 X 10⁹ dyne/cm² at the ratio 2 of the flow rate of 0₂/TE-OS(N₂). It changes in a range from +0.1 X 10⁹ dyne/cm² to +0.35 X 10⁹ dyne/cm².

Fig.8(b) is a characteristic diagram showing the dependency of the stress in a range 0.75 SLM to 1.75 SLM of the total gas flow amount. As shown in Fig.8(b), the stress becomes small as the total flow amount of 0₂+TEOS(N₂) is increased. It changes in a range from +0.5 X 10⁹ dyne/cm² to 0 dyne/cm².

Fig.8(c) is a characteristic diagram showing the dependency of the stress in a range 0.2 Torr to 0.6 Torr of the gas pressure. As shown in Fig.8(c), the stress reduces gradually from the negative value to zero as the total gas pressure of 0₂+TEOS(N₂) is increased. It changes in a range from -0.5 X 10⁹ dyne/cm² to +0.8 X 10⁹ dyne/cm².

Fig.8(d) is a characteristic diagram showing the dependency of the stress in a range 250 °C to 350 °C of the substrate temperature. As shown in Fig.8(d), the stress has the minimum value 0 dyne/cm² at the substrate temperature 300 °C. It changes in a range from 0 dyne/cm² to +0.6 X 10⁹ dyne/cm².

Fig.9(a) is a characteristic diagram showing the dependency of the stress in a range -45mm to +45 mm of the wafer location. As shown in Fig.9(a), the stress becomes gradually small from the positive value to zero and the negative value of the stress becomes gradually large in the negative side as the wafer location is risen upwardly. The stress value changes in a range from +0.7 X 10⁹ dyne/cm² to -0.1 X 10⁹ dyne/cm2.

Fig.9(b) is a characteristic diagram showing the dependency of the stress in a range 1 kW to 2 kW of the RF electric power. As shown in Fig.9(b), the stress becomes gradually small from the positive value to zero and the negative value of the stress becomes gradually large in the negative side as the RF electric power is increased. The stress value changes in a range from +0.7 X 10⁹ dyne/cm² to -0.65 X 10⁹ dyne/cm2.

Fig.9(c) is a characteristic diagram showing the dependency of the stress in a range 20 A to 80 A of the inner source solenoid electric current. As shown in Fig.9(c), the stress becomes large as the inner source solenoid electric current is increased. It changes in a range from +0.1 X 10⁹ dyne/cm² to +0.4 X 10⁹ dyne/cm2.

Fig.9(d) is a characteristic diagram showing the dependency of the stress in a range 20 A to 80 A of the outer source solenoid electric current. As shown in Fig.9(d), the stress has the maximum value +0.5 X 10⁹ dyne/cm² at the outer source solenoid electric current 60 A, and it changes in a range from +0.0 X 10⁹ dyne/cm² to +0.5 X 10⁹ dyne/cm².

As described in detail above, the stress of the silicon oxide film formed by the film forming method according to the embodiment of the present invention is small. Therefore, the stress of the oxide film is sufficiently small for the insulating film used in the semiconductor device.

### 4) Refractive index of formed film

A refractive index of the silicon oxide film has been measured when it was formed while setting each of all parameters to its standard value.

The refractive index has been measured by using an ellipsometer. The refractive index is an important item to evaluate the fineness of the silicon oxide film. Note that the larger the refractive index becomes, the finer the film becomes.

The result thereof was 1.452. This value is similar to the refractive index of the thermal oxide film. It can be concluded that the oxide film has a sufficiently good quality as the insulating film used in the semiconductor device.

In the above embodiment, the silicon oxide film has been formed by using 0₂+TEOS(N₂) gas, but SiH₄+0₂ gas can be used. PSG film, BSG film, BPSG film etc. can also be formed by adding a dopant to these gases. In addition, the silicon nitride film can be formed by using N₂, NH₃, H₂NNH₂ as the reaction gas for supplying nitrogen.

### (B) Explanation of an embodiment according to the second film forming method:

### (i) Embodiment according to the second film forming method

Then a film forming method using the CVD film forming apparatus in Fig.1 and according to an embodiment of the second film forming method of the present invention will be explained. The 0₂ gas is used as the first reaction gas, and the SiH₄ gas is used as the second reaction gas.

Conditions for forming the film are pointed out as follows.
(a) Ratio of flow rate of 0₂/SiH₄ (standard value =3)
(b) Each reaction gas flow amount and total gas flow amount (standard value of 0₂ gas flow amount=30 SCCM, standard value of SiH₄ gas flow amount=30 SCCM, and standard value of total gas flow amount=60 SCCM)
(c) Gas pressure (standard value=20 mTorr)
(d) Wafer location (Assuming that the lower end of the film forming chamber 7 is regarded as zero, the location upper zero is shown. standard value=161 mm)
(e) Substrate bias [P_{B]} (standard value of the frequency=100 kHz, standard value of the electric power=200 W)
(g) RF electric power applied to the external antenna 2 [P_{RF]} (standard value=13.56 MHz, standard value of the electric power=1.0 kW)
(h) Inner source solenoid electric current [l_{is]} (standard value=50 A)
(i) Outer source solenoid electric current [l_{os]} (standard value=60 A)

In this embodiment, in order to examine characteristics of the formed film, various samples has been prepared, with changing each parameter. The above standard values denote fixed values of other parameters while the concerned parameter is being changed.

In this embodiment, the gas discharging portion 9a was arranged fixedly at about 230 mm distance upwardly from the bottom of the film forming chamber 7. Accordingly, the gas discharging portion 9a was set at the standard value 161 mm of the wafer location and at about 70 mm distance over the surface of the wafer 15.

Although the wafer was not heated especially, the temperature thereof was raised to a certain degree by the plasma radiation.

First, interiors of the plasma generating chamber 1 and the film forming chamber 7 are exhausted by the turbo molecular pump, and are held less than the pressure 10-³ Torr.

Then, the wafer holder 12 on which the wafer 15 has been placed is moved upwardly, and is set at a predetermined location in the film forming chamber 7.

Next, the 0₂ gas of a predetermined amount is introduced into the plasma generating chamber 1 via the first reaction gas introducing pipe 8. The SiH₄ gas of a predetermined amount is introduced into the film forming chamber 7 via the second reaction gas introducing pipe 9. Subsequently, the gas pressure in the film forming chamber 7 is adjusted, and is held at a predetermined pressure.

The inner source solenoid 5 and the outer source solenoid 6 are energized by respectively flowing a predetermined electric current to generate the magnetic field. Preselected RF electric power is applied to the external antenna 2 via the matching network 3. Thereby, the 0₂ gas is activated, and then the plasma is generated in the helicon mode.

Furthermore, the plasma in the helicon mode flows into the film forming chamber 7 downwardly to activate the SiH₄ gas. Then, the activated SiH₄ gas and the oxygen plasma react to each other, and the deposition of the silicon oxide film is commenced on the wafer 15 at a predetermined deposition rate.

While keeping this state for a predetermined time, the silicon oxide film having a predetermined thickness is formed.

In the film forming method of the above embodiment, the wafer 15 was not heated. However, by heating the substrate suitably at a temperature of about 200 to 300 °C, the quality of the formed silicon oxide film could be adjusted.

(ii) Explanation of examination result of the characteristics of the silicon oxide film according to the embodiment of the second film forming method.

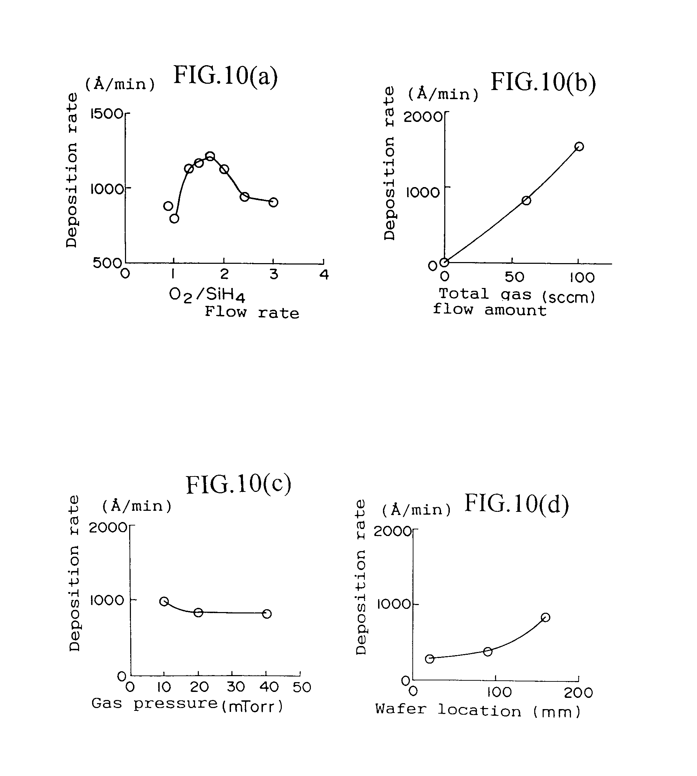

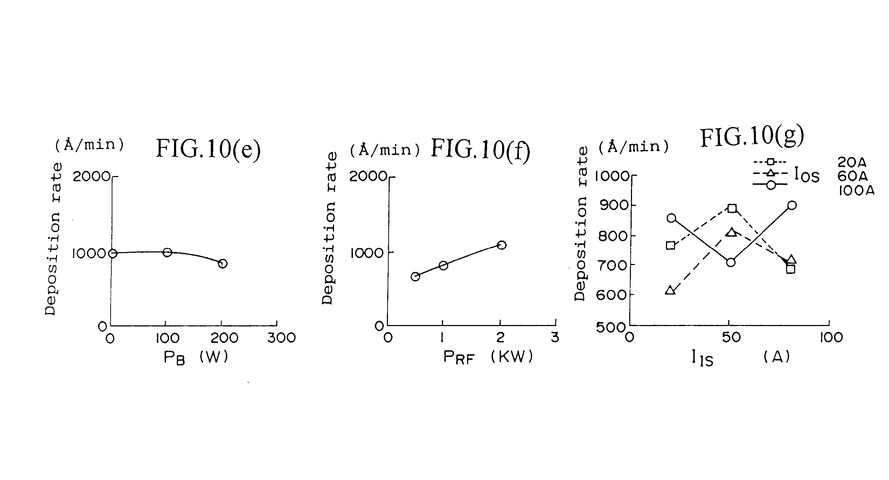

As to the silicon oxide film formed as above, results of deposition rate of the film, ratio of the deposition rate, hydrogen bond and water in the film, SiO peak wave number in the film, ratio of the etching rate of the film, and refractive index and stress will be discussed. Results are shown in Figs.10 to 15.

1) Deposition rate of the film

Deposition rates (A/min) of the silicon oxide film in a predetermined range of each parameter are shown in Figs.10(a) to (g).

Fig.10(a) is a characteristic diagram showing the dependency of the deposition rate in a range 0.8 to 3 of the ratio of the flow rate of 0₂/SiH₄. As shown in Fig.10(a), the deposition rate has the minimum value 800 A/ min when the ratio of the flow rate of 0₂/SiH₄ is about 1. After this, the deposition rate becomes high as the ratio of the flow rate is increased. The deposition rate has the maximum value 1250 A/min at the ratio of the flow rate about 1.8, and thereafter the deposition rate becomes low as the ratio of the flow rate is increased. It becomes 950 A/min at the ratio of the flow rate 3.

Fig.10(b) is a characteristic diagram showing the dependency of the deposition rate in a range 0 SCCM to 100 SCCM of the total flow amount of the reaction gas. As shown in Fig.10(b), the deposition rate increases linearly as the total gas flow amount of 0₂+SiH₄ is increased. It becomes about 1600 A/min when the total gas flow amount is 100 SCCM.

Fig.10(c) is a characteristic diagram showing the dependency of the deposition rate in a range 10 mTorr to 40 mTorr of the gas pressure in the film forming chamber 7. As shown in Fig.10(c), the deposition rate seldom depends upon the gas pressure of 0₂+SiH₄ gas. It is 1000 A/min at the gas pressure 10 mTorr. It slightly reduces as the gas pressure becomes high, and it is 800 A/min when the gas pressure is 40 mTorr.

Fig.10(d) is a characteristic diagram showing the dependency of the deposition rate in a range 20mm to 161 mm of the wafer location. As shown in Fig.10(d), the deposition rate becomes large as the wafer location is risen upwardly, i.e., as the wafer 15 comes to close to the gas discharging portion 9a. It changes in a range from 300 A/min to 900 A/min.

Fig.10(e) is a characteristic diagram showing the dependency of the deposition rate in a range 0 W to 200 W of the substrate bias [P_{B]}. As shown in Fig.10(e), the deposition rate is about 1000 A/min when the substrate bias is zero, and thereafter it decreases as the substrate bias is increased. It takes a value of about 900 A/min when the substrate bias is 200 W.

Fig.10(f) is a characteristic diagram showing the dependency of the deposition rate in a range 0.5 kW to 2 kW of the RF electric power [P_{RF]}. As shown in Fig.10(f), the deposition rate has about 650 A/min at the RF electric power 0.5 kW, and thereafter it becomes large as the RF power is increased. The deposition rate becomes about 1100 A/min when the RF power is 1.5 kW.

Fig.10(g) is a characteristic diagram showing the dependency of the deposition rate in a range 20 A to 80 A of the inner source solenoid electric current [l_{is]}. The deposition rate is examined under three outer source solenoid electric currents [l_{os]} 20 A, 60 A, and 100A.

As shown in Fig.10(g), in case lₒₛ=20 A (shown by a rectangular mark), the deposition rate has the maximum value about 900 A/min when the Iₗₛ=50 A. It changes in a range from 700 A/min to 900 A/min.

In case Iₒₛ=60A(shown by a triangular mark), the deposition rate has the maximum value about 820 A/min when the Iₗₛ=50A. It changes in a range from 600 A/min to 820 A/min.

In case lₒₛ=100 A (shown by a round mark), the deposition rate has the minimum value about 700 A/min when the Iₗₛ=50A. It changes in a range from 700 A/min to 900 A/min.

As explained above, according to the film forming method according to the present invention, the large deposition rate which is enough for practical use can be achieved.

### 2) Ratio of deposition rate of the silicon oxide film

A ratio of deposition rate of the silicon oxide film has been examined in a predetermined range of each parameter. Results thereof are shown in Figs.11 (a) to (g). The ratio of deposition rate is defined as follows. That is, it is the ratio of the deposition rate of the silicon oxide film, which is formed by the thermal CVD method using mixed gas of TEOS+0₃ on the silicon oxide film formed by the plasma CVD method using the mixed gas of O₂+SiH₄, to the deposition rate of the silicon oxide film, which is formed directly on the silicon substrate by the thermal CVD method using mixed gas of TEOS+0₃. The above ratio of the deposition rate is used to examine the film quality in a respect of fitness to the silicon oxide film formed by the thermal CVD method using the mixed gas of TEOS+0₃. It is determined that the more the ratio becomes near 1, the better the film quality becomes.

Conditions for forming the film in the thermal CVD method using the mixed gas of TEOS+0₃ are raised as follows:
(a) TEOS temperature: 65 °C
(b) Carrier gas of TEOS: N₂gas, Flowamount: 1.5 slm
(c) Ozone containing oxygen gas: containing rate of 0₃ 5 vol %, Flow amount: 7.5 slm
(d) Wafer temperature: 400 °C

Fig. 11 (a) is a characteristic diagram showing the dependency of the ratio of the deposition rate in a range 0.8 to 3 of the ratio of the flow rate of 0₂/SiH₄. As shown in Fig.11 (a), the ratio of the deposition rate becomes substantially 1 when the ratio of the flow rate of 0₂/SiH₄ is within 0.8 to 1, and the film has the best fitness. Thereafter, the ratio of the deposition rate abruptly becomes small as the ratio of the flow rate is increased, and it falls to about 0.5. After this, the deposition rate becomes constant even when the ratio of the flow rate is increased.

Fig.11(b) is a characteristic diagram showing the dependency of ratio of the deposition rate in a range 60 SCCM to 100 SCCM of the total flow amount of the reaction gas. As shown in Fig.11 (b), the ratio of the deposition rate has about 0.85 when the total gas amount of 0₂+SiH₄ is 60 SCCM, and thereafter it increases linearly to 1 as the total gas flow amount is increased. It becomes about 0.93 when the total gas flow amount is 100 SCCM.

Fig.11(c) is a characteristic diagram showing the dependency of the ratio of the deposition rate in a range 10 mTorr to 40 mTorr of the gas pressure in the film forming chamber 7. As shown in Fig.11 (c), the ratio of the deposition rate shows about 0.8 at the gas pressure 10 mTorr of 0₂+SiH₄, and thereafter it comes to close to 1 as the gas pressure is increased. It becomes about 0.95 when the gas pressure is 40 mTorr.

Fig.11(d) is a characteristic diagram showing the dependency of the ratio of the deposition rate in a range 20mm to 161 mm of the wafer location. As shown in Fig.11 (d), the ratio of the deposition rate has a value of about 1.1 at the wafer location 20 mm, and it becomes small as the wafer location is risen upwardly. The ratio of the deposition rate passes a value of about 1 near the wafer location 20 mm, and falls to the minimum value about 0.75 near the wafer location 100 mm. Thereafter, it rises again as the wafer location is increased upwardly, and it becomes 0.85 at the wafer location 161 mm.

Fig.11(e) is a characteristic diagram showing the dependency of the ratio of the deposition rate in a range 0 W to 200 W of the substrate bias [P_{B]}. As shown in Fig.11 (e), the ratio of the deposition rate is about 0.75 when the substrate bias is zero, and thereafter it becomes large as the substrate bias is increased. It passes a value of about 1 near the wafer bias 80 mm, and rises to the maximum value about 1.05 when the wafer bias is 100 W. Thereafter, it decreases as the wafer bias is increased, and it becomes about 0.85 at the wafer bias 200 W.

Fig.11(f) is a characteristic diagram showing the dependency of the ratio of the deposition rate in a range 0.5 kW to 2 kW of the RF electric power [P_{RF]}. As shown in Fig.11 (f), the ratio of the deposition rate has about 0.95 at the RF electric power 0.5 kW, and thereafter it decreases linearly as the RF power is increased. Then it becomes about 0.63 when the RF electric power is 2 kW.

Fig.11(g) is a characteristic diagram showing the dependency of the ratio of the deposition rate in a range 20 Ato 80 Aof the inner source solenoid electric current [l_{is]}. The ratio of the deposition rate is examined under three outer source solenoid electric currents [l_{os]} 20 A, 60 A, and 100 A.

As shown in Fig.11 (g), in case lₒₛ=20A(shown by a rectangular mark), the ratio of the deposition rate increases linearly from 0.85 to 0.9.

In case lₒₛ=60A(shown by a triangular mark), the ratio of the deposition rate increases linearly from 0.8 to 0.85.

In case lₒₛ=100 A (shown by a round mark), the ratio of the deposition rate has a value of about 1 when the Iₗₛ=20A. Thereafter, it decreases and has the minimum value about 0.77 when the Iₗₛ=50A. It increases again as the lᵢₛ becomes large, and it takes a value of about 0.97 at the Iₗₛ=80A.

As specifically explained above, according to the film forming method according to the present invention, it is desirable in respect of fitness that the ratio of the flow amount is about 1, as shown in Fig.11(a). Also, by adjusting the wafer location and the substrate bias in addition to the ratio of the flow amount, the ratio of the deposition rate can be controlled. The ratio of the deposition rate of 1 can be achieved by adjusting theses parameters suitably.

### 3) SiOH bond, SiH bond and SiO bond in the film

As to four type silicon oxide films which are formed by changing the ratio of the flow amount of 0₂/SiH₄, SiOH bond, SiH bond, and SiO bond in the film have been examined by means of a Fourier- transform infrared spectroscopy (FTIR).

Results thereof are shown in Fig.12. In Fig.12, the axis of ordinate represents the absorption strength, and the axis of abscissa represents the wave number (cm-¹).

Meanwhile, it is known that the SiOH bond has an absorption peak near the wave number of 3600cm-¹ and the SiH bond has an absorption peak near the wave number of 2000cm⁻¹. In case of the silicon oxide film according to the embodiment of the present invention, as shown in Fig.12, no absorption peak is observed near the wave numbers of 3600 cm-¹ and 2000 cm-¹ at every rate of the flow amount. This fact shows that there exists no SiOH bond and SiH bond in the formed silicon oxide film and that the oxidation of SiH₄ is carried out sufficiently. Therefore, the silicon oxide film having fine and good film quality and including no water can be formed.

Then the absorption peak which appears nearthe wave number of 1080 cm-¹ indicates the SiO bond. This shows that Si0₂, the composition of which is similar to that of the thermal oxide film and is fine, can be generated as the wave number of the absorption peak becomes close to 1080 cm-¹.

4) SiO peak wave number in the film and ratio of the etching rate of the film

SiO peak wave numbers ν_{SIO} (cm-¹) of the silicon oxide film have been examined in a predetermined range of each parameter. ν_{SIO} indicates SiO bond states in the silicon oxide film. Si0₂, the composition of which is similar to that of the thermal oxide film and is fine, can be generated as the ν_{SIO} becomes close to 1080 cm-¹. Examinations has been made by means of the FTIR. Results thereof are shown in Figs.13(a) to (g).

An examination result of the dependency of the ratio of the etching rate in a range 0.8 to 3 of the ratio of the flow amount of 0₂/SiH₄ is shown in Fig.13(h). The ratio of the etching rate is defined as a ratio of the etching rate of the silicon oxide film formed by the plasma CVD method of the embodiment to the etching rate of the silicon oxide film formed by the thermal oxidation. The etching rate has been measured using 1.2 % HF aqueous solution. The film quality of the formed silicon oxide film becomes close to that of the thermal oxide film and fine as the ratio of the etching rate becomes close to 1. Thus, for example, it is desirable for an insulating film used in the semiconductor device. Incidentally, the etching rate of the silicon oxide film formed by the thermal oxidation is about 98 A_{/}min.

Results of the examination are discussed hereinbelow.

Fig.13(a) is a characteristic diagram showing the dependency of the ν_{SIO} within a range 0.8 to 3 of the ratio of the flow rate of 0₂/SiH₄. As shown in Fig.13(a), the ν_{SIO} has 1050 cm-¹ when the ratio of the flow rate is 0.8, and thereafter it comes abruptly up to 1080 cm-¹ when the ratio of the flow amount is increased. It reaches 1080 cm-¹ near the ratio of the flow rate 1.03, and thereafter it has a constant value of 1080 cm-¹ even though the ratio of the flow rate is increased. It can be derived that ν_{SIO} is small where the ratio of the flow amount of 0₂/SiH₄ is low since there exists much Si rather than oxygen in the formed film. As a result, this indicates that the film becomes fine.

It could be confirmed from the fact that, as shown in Fig.13(h), the film has the etching rate close to that of the silicon oxide film formed by the thermal oxidation at the small ratio of the flow amount if the silicon oxide film formed as above is etched.

Fig.13(b) is a characteristic diagram showing the dependency of ν_{SIO} in a range 60 SCCM to 100 SCCM of the total flow amount of the reaction gas. As shown in Fig. 13(b), ν_{SIO} has about 1060 cm-¹ when the total gas amount of 0₂+SiH₄ is 60 SCCM. Thereafter it decreases linearly as the total gas flow amount is increased, and it becomes about 1045 cm-¹ when the total gas flow amount is 100 SCCM.

Fig.13(c) is a characteristic diagram showing the dependency of the ν_{SIO} in a range 10 mTorr to 40 m Torr of the gas pressure in the film forming chamber 7. As shown in Fig.13(c), the ν_{SIO} shows about 1060 cm-¹ for the change of the gas pressure of 0₂+SiH₄, and it does not so much change.

Fig.13(d) is a characteristic diagram showing the dependency of the ν_{SIO} in a range 20mm to 161 mm of the wafer location. As shown in Fig.13(d), the ν_{SIO} has a value of about 1050 cm-¹ at the wafer location 20 mm, and it increases linearly as the wafer location is raised upwardly. It becomes about 1060 cm-¹ at the wafer location 161 mm.

Fig.13(e) is a characteristic diagram showing the dependency of the ν_{SIO} in a range 0 W to 200 W of the substrate bias [P_{B]}. As shown in Fig.13(e), the ν_{SIO} is about 1065 cm-¹ when the substrate bias is zero. After this, it decreases linearly as the substrate bias is increased. It becomes about 1055 cm-¹ at the wafer bias 200 W.

Fig.13(f) is a characteristic diagram showing the dependency of the ν_{SIO} in a range 0.5 kW to 2 kW of the RF electric power [P_{RF]}. As shown in Fig.13(f), the ν_{SIO} has about 1050 cm-¹ at the RF electric power 0.5 kW. Thereafter, it increases as the RF power is increased, and it becomes about 1065 cm-¹ when the RF electric power is 2 kW.

Fig.13(g) is a characteristic diagram showing the dependency of the ν_{SIO} in a range 20 A to 80 A of the inner source solenoid electric current [l_{is]}. The ν_{SIO} is examined under three outer source solenoid electric currents [l_{os]} 20 A, 60 A, and 100 A.

As shown in Fig.13(g), in case lₒₛ=20 A (shown by a rectangular mark), the ν_{SIO} decreases linearly from about 1065 cm-¹ to about 1055 cm-¹.

In case lₒₛ=60 A(shown by a triangular mark), the ν_{SIO} changes in a range from about 1055 cm-¹ to about 1058 cm⁻¹.

In case lₒₛ=100 A (shown by a round mark), the ν_{SIO} changes in a range from about 1058 cm-¹ to about 1063 cm⁻¹.

As specifically explained above, according to the film forming method according to the present invention, the ν_{SIO} of about 1080 cm-¹ has been derived at the ratio of the flow amount of about 1.03 or more, as shown in Fig.13(a). When setting conditions in the CVD method, it is preferable to bring the ν_{SIO} as close to 1080 cm-¹ as possible. As can be seen from the graph of the rate of the etching rate in Fig.13(h), there are some cases where high fineness of the film exists at the ν_{SIO} less than 1080 cm-¹. Therefore, taking other parameter into consideration, it is necessary to determine the film quality totally.

### 5) Refractive index of the film

Refractive indexes of the silicon oxide film have been examined in a predetermined range of each parameter. Refractive indexes has been measured by using the ellipsometer. Results thereof are shown in Figs.14(a) to (g).

Fig.14(a) is a characteristic diagram showing the dependency of the refractive index in a range 0.8 to 3 of the ratio of the flow rate of 0₂/SiH₄. As shown in Fig.14(a), the refractive index has 1.63 when the ratio of the flow rate is 0.8. Thereafter, the refractive index abruptly becomes small as the ratio of the flow rate is increased. It then falls to about 1.49 at the ratio of the flow rate of 1. After this, the refractive index slightly decreases at the ratio of the flow rate of 1 or more, and it becomes 1.45 when the ratio of the flow rate is 3. It can be considered that the same reason why ν_{SIO} is low in Fig.13(a) can be applied to that the refractive index at the ratio of the flow rate of 0.8 is high. That is, it seems that, due to excessive silicon atoms in the silicon oxide film, such high refractive index is caused at the ratio of the flow rate of 0.8.

Fig.14(b) is a characteristic diagram showing the dependency of the refractive index in a range 60 SCCM to 100 SCCM of the total flow amount of the reaction gas. As shown in Fig.14(b), the refractive index has about 1.52 when the total gas amount of 0₂+SiH₄ is 60 SCCM. After this, it increases linearly as the total gas flow amount is increased, and it becomes about 1.58 when the total gas flow amount is 100 SCCM.

Fig.14(c) is a characteristic diagram showing the dependency of the refractive index in a range 10 m Torr to 40 m Torr of the gas pressure in the film forming chamber 7. As shown in Fig.14(c), the refractive index shows about 1.50 constantly even when the gas pressure of 0₂+SiH₄ is changed. It seldom changes for the change of the gas pressure.

Fig.14(d) is a characteristic diagram showing the dependency of the refractive index in a range 20mm to 161 mm of the wafer location. As shown in Fig.14(d), the refractive index shows about 1.52 constantly even when the wafer location is changed. It seldom changes for the change of the wafer location.

Fig.14(e) is a characteristic diagram showing the dependency of the refractive index in a range 0 W to 200 W of the substrate bias [P_{B]}. As shown in Fig.14(e), the refractive index is about 1.52 when the substrate bias is zero. Thereafter, it linearly decreases as the substrate bias is increased. It becomes about 1.5 at the wafer bias 200 W.

Fig.14(f) is a characteristic diagram showing the dependency of the refractive index in a range 0.5 kW to 2 kW of the RF electric power [P_{RF]}. As shown in Fig.14(f), the refractive index has about 1.53 at the RF electric power 0.5 kW, and thereafter it decreases as the RF power is increased. It becomes about 1.48 when the RF electric power is 2 kW.

Fig.14(g) is a characteristic diagram showing the dependency of the refractive index in a range 20 A to 80 A of the inner source solenoid electric current [l_{is]}. The refractive index has been examined under three outer source solenoid electric currents [l_{os]} 20 A, 60 A, and 100 A.

As shown in Fig.14(g), in case lₒₛ=20 A (shown by a rectangular mark), the refractive index has about 1.47 at the Iₗₛ=20 A, and rises to about 1.5 at the Iₗₛ=50 A, and has the substantially same value at the Iₗₛ=80 A as that at the Iₗₛ=50.

In case lₒₛ=60A(shown by a triangular mark), the refractive index decreases linearly from about 1.52 to about 1.5.

In case lₒₛ=100 A (shown by a round mark), the refractive index changes in a range from about 1.5 to about 1.49.

As specifically explained above, according to the film forming method according to the present invention, the refractive index could be controlled by adjusting mainly total gas flow amount and the RF electric power. It can be concluded that, because of the controllable value of the refractive index, the film has sufficiently good film quality as the insulating film for use in the semiconductor device.

### 6) Stress of the film

Dependencies of the stress of the formed film in a predetermined range of each parameter has been examined. A measurement of the stress has been calculated from a warping amount of the wafer 15, as effected in the ordinary case.

Results thereof are shown in Figs.15(a) to (g). The axis of ordinate represents the stress (X 10⁹ dyne/cm²), and the axis of abscissa represents the changing range of each parameter. In Figs.15(a) to (g), a positive sign represents a tensile stress, and a negative sign represents a compressive stress. Also, a white round mark represents a value measured immediately after the film is formed, and a black round mark represents a value measured after the film is left in the air having the humidity of 50 % to 60 % for three weeks.

Depending upon a kind of stress and a change of stress with the time passage, the film quality can be examined. That is, the film which is made to be fine has the compressive stress. However, in such films that have the compressive stress and seem to be fine, there exist some films which absorbs water in the air and changes their stress by the thermal treatment. The stability of the film is evaluated by observing the change of the stress with the time passage while the film is left in the air.

Fig.15(a) is a characteristic diagram showing the dependency of the stress in a range 0.8 to 3 of the ratio of the flow rate of 0₂/SiH₄. As shown in Fig.15(a), the stress has +1.8 X 10⁹ dyne/cm² at the ratio 0.8 of the flow rate of 0₂/SiH₄. It decreases as the ratio of the flow rate is increased. It changes in a range from +1.25 X 10⁹ dyne/cm² to +1.8 X 10⁹ dyne/cm². If the film was left in the air for three weeks, the stress changed slightly.

Fig.15(b) is a characteristic diagram showing the dependency of the stress in a range 60 SCCM to 100 SCCM of the total gas flow amount of the reaction gas. As shown in Fig.15(b), the stress becomes small as the total flow amount of 0₂+SiH₄ is increased. It changes in a range from +0.3 X 10⁹ dyne/cm² to -1.8 X 10⁹ dyne/cm². If the film was left in the air for three weeks, the stress changed slightly.

Fig.15(c) is a characteristic diagram showing the dependency of the stress in a range 10 mTorr to 40 mTorr of the gas pressure. As shown in Fig.15(c), the stress does not so much change for the change of the gas pressure of 0₂+SiH₄, and has about -1.5 X 10⁹ dyne/cm². If the film was left in the airfor three weeks, the stress does not changed.

Fig.15(d) is a characteristic diagram showing the dependency of the stress in a range 20mm to 161 mm of the wafer location. As shown in Fig.15(d), the stress has -1.0 X 10⁹ dyne/cm² when the wafer location is 20 mm, and it becomes large in the negative side as the wafer location is risen upwardly. It has the negative maximum value of-2.0 X 10⁹ dyne/cm² when the wafer location is about 90 mm. Further the stress becomes small in the negative side as the wafer location is risen upwardly, and it has -1.4 X 10⁹ dyne/cm² when the wafer location is 161 mm. If the film was left in the air for three weeks, the stress does not changed.

Fig.15(e) is a characteristic diagram showing the dependency of the stress in a range 0 W to 200 W of the substrate bias. As shown in Fig.15(e), the stress has about +0.4 X 10⁹ dyne/cm² when the substrate bias is zero. It passes a stress zero point at the substrate bias 10 Wand changes to the negative stress as the substrate bias increases. Further it becomes large in the negative side as the substrate bias is increased, and it has about -1.1 X 10⁹ dyne/cm² at the substrate bias 100 W. In addition to, it increases slightly in the negative side as the substrate bias is increased, and it becomes about -1.5 X 10⁹ dyne/cm² at the substrate bias 200 W.

If the film was left in the air for three weeks, the stress extremely changed at the substrate bias of zero from about +0.4 X 10⁹ dyne/cm² to about -1.1 X 10⁹ dyne/cm². This is because the film causes a stress relaxation in the film by absorbing water in the air. Such large changing value suggests that the film has a hygroscopicity and that the film quality is not fine. Therefore, the application of the substrate bias is extremely effective in improving the fineness of the film.

Fig.15(f) is a characteristic diagram showing the dependency of the stress in a range 0.5 kW to 2 kW of the RF electric power. As shown in Fig.15(f), the stress has about -1.0 X 10⁹ dyne/cm² when the RF power is 0.5 kW, and it becomes gradually large in the negative side as the RF electric power is increased. It has about -1.5 X 10⁹ dyne/cm² at the RF power of 1 kW. Further, the negative value of the stress becomes small as the RF electric power is increased. The stress becomes about -0.5 X 10⁹ dyne/cm² when the RF power is 2 kW. If the film was left in the air for three weeks, the stress does not changed.

Fig.15(g) is a characteristic diagram showing the dependency of the stress in a range 20 A to 80 A of the inner source solenoid electric current [l_{is]}. The stress has been examined under three outer source solenoid electric currents [l_{os]} 20 A, 60 A, and 100 A.

As shown in Fig.15(g), in case lₒₛ=20 A (shown by a rectangular mark), the negative value of the stress becomes small as the Iₗₛ is increased. It changes in a range from -1.45 X 10⁹ dyne/cm² to -1.1 X 10⁹ dyne/cm2.

In case lₒₛ=60A(shown by a triangular mark), the stress has -1.4 X 10⁹ dyne/cm² at the Iₗₛ of 20 A, and it scarcely changes until the Iₗₛ reaches 50 A. Then the negative value of the stress becomes large as the Iₗₛ is increased, and it becomes -1.75 X 10⁹ dyne/cm² when the Iₗₛ is 80 A.

In case lₒₛ=100 A (shown by a round mark), the stress seldom changes for the change of the Iₗₛ, and it has about -1.3 X 10⁹ dyne/cm² constantly.

As described specifically above, according to the film forming method of the embodiment of the present invention, the stress of the formed silicon oxide film could be controlled by mainly adjusting the ratio of the flow amount of 0₂/SiH₄ and the substrate bias. As a result, it is possible to form the film which has the compressive stress and is fine and stable.

(C) Comparison example to the embodiment of the film forming method of the present invention

For the purpose of comparison, characteristics of the silicon oxide film which has been formed by means of the parallel-plate type plasma CVD method using SiH₄+N₂ gas will be explained.

(i) Sample forming of the comparison example

Film forming conditions in the comparison example are raised as follows.
(a) Ratio of flow amount of N₂0/SiH₄ (standard value=11 )
(b) Flow amount of each reaction gas and total gas flow amount (N₂0=220 SCCM, SiH₄=20 SCCM, standard value=240 SCCM)
(c) Gas pressure (standard value=1 Torr)
(d) Substrate temperature (standard value=350 °C)
(e) RF power [P_{RF]} (standard value of the frequency=13.56 MHz, standard value of the electric power=200 W)

In order to compare the above embodiment with comparison examples, various samples has been formed as a comparison sample, while changing each condition. The above standard values denote fixed values of other parameters while the concerned parameter is being changed.

Film forming conditions in the comparison example are characterized in that, in comparison with film forming conditions of the embodiment, the ratio of the flow amount is high and also the gas pressure is high.

Not SiH₄+0₂ gas used in the embodiment according to the second film forming method, but SiH₄+N₂0 gas has been used. This is because the SiH₄+0₂ gas is not suitable for the parallel plate type plasma CVD method since the SiH₄ has strong reaction so that it generates much powders when being used together with O2.

(ii) Explanation of examination result of the film quality of the formed film

Like the embodiment according to the above second film forming method, ν_{SIO}, SiOH bond, SiH bond etc. in the film, refractive index, and ratio of etching rate of the silicon containing insulating film formed under the conditions in (i) have been examined. These results are shown in Figs.16 to 19.

### 1) SiO peak wave number ν_{SIO} of the film

SiO peak wave number ν_{SIO}(cm⁻¹) of the silicon oxide film has been examined in a predetermined range of each parameter. The examination has been effected by means of FTIR. The results thereof are given in Figs.16(a) to (c).

Fig.16(a) is a characteristic diagram showing the dependency of the ν_{SIO} in a range 5 to 23 of the ratio of the flow rate of N₂0/SiH₄. As shown in Fig.16(a), the ν_{SIO} has 1035 cm-¹ when the ratio of the flow rate is 5. The ν_{SIO} has 1065 cm-¹ when the ratio of the flow rate is 10. If the ratio of the flow rate is changed from 10 to 23, the ν_{SIO} slightly increases to 1070 cm-¹.

In this manner, in order to form the silicon containing insulating film including a lot of bonds which become Si0₂ stoichiometrically, the flow amount of N₂0 must be considerably increased rather than the embodiment.

Fig.16(b) is a characteristic diagram showing the dependency of ν_{SIO} in a range 180 SCCM to 650 SCCM of the total flow amount of N₂0/SiH₄. As shown in Fig. 16(b), ν_{SIO} decreases linearly for the change of the total gas flow amount, and it changes in a range from 1068 cm-¹ to 1042 cm-¹.

Fig.16(c) is a characteristic diagram showing the dependency of the ν_{SIO} in a range 100 W to 300 W of the RF electric power [P_{RF]}. As shown in Fig.16(f), the ν_{SIO} linearly decreases for the change of the RF power, and it changes in a range from 1068 cm-¹ to 1042 cm-1.

### 2) Containing amount of SiOH bond, SiH bond and NH bond in the film

SiOH bond, SiH bond and NH bond in the silicon oxide film have been examined in a predetermined range of each parameter. The examination has been effected by means of the FTIR. The results thereof are given in Figs.17(a) to (c). In Figs.17(a) to (c), a white triangular mark represents the NH bond, a black triangular mark represents the SiH bond, and a rectangular mark represents the SiOH bond.

Fig.17(a) is a characteristic diagram showing the dependency of the absorption strength (pm-^{I}) of SiOH bond etc. in a range 5 to 23 of the ratio of the flow rate of N₂0/SiH₄. As shown in Fig.17(a), in case of the NH bond, the absorption strength is 0.09 µm⁻¹ at the ratio of the flow rate of 5, but it disappears at the ratio of the flow rate 11 or more. In case of the SiH bond, the absorption strength is 0.03 µm⁻¹ at the ratio of the flow rate of 5, and it decreases to 0.01 µm⁻¹ at the ratio of the flow rate of 11, but does not perfectly disappear yet. It perfectly disappears at the ratio of the flow rate of 23. In case of the SiOH bond, the absorption strength is zero at the ratio of the flow rate of 5, but it has 0.03 µm⁻¹ at the ratios of the flow rate of 11 and 23 and therefore the SiOH bond remains in the film.

Fig.17(b) is a characteristic diagram showing the dependency of the absorption strength (pm-^{I}) of SiOH bond etc. in a range 180 SCCM to 650 SCCM of the total flow amount of N₂0/SiH₄. As shown in Fig. 17(b), in case of the NH bond, the NH bond does not remain in the film at the total gas flow amount of 180 SCCM, but remains at the total gas flow amount of 230 SCCM or more. In case of the SiH bond, the SiH bond does not remain in the film at the total gas flow amount of 250 SCCM or less, but remains at the total gas flow amount of 250 SCCM or more. In case of the SiOH bond, the absorption strength decreases when the the total gas flow amount is increased, but the SiOH bond remains in the film.

Fig.17(c) is a characteristic diagram showing the dependency of a containing rate (%) of each of the SiOH bond, the SiH bond and the NH bond in a range 100 W to 300 W of the RF electric power [P_{RF]}. As shown in Fig.17(c), in case of the NH bond, the NH bond does not remain in the film only when the RF power is 200 W, but it remains more than 1 % at other total gas flow amount. Also, in case of the SiH bond, the SiH bond does not remain in the film only when the RF power is 200 W, but it remains about 1 % to 4 % at other total gas flow amount. In case of the SiOH bond, the SiOH bond remains in the film over whole total gas flow amount.

As described above, in the comparison example, the film quality is inferior to that of the embodiment since the SiOH bond, the SiH bond and the NH bond are included considerably in the formed silicon containing insulating film.

### 3) Refractive index of the film

The refractive index of the silicon oxide film has been examined in a predetermined range of each parameter. The results thereof are given in Figs.18(a) to (c).

Fig.18(a) is a characteristic diagram showing the dependency of the refractive index in a range 5 to 23 of the ratio of the flow amount of N₂0/SiH₄. As shown in Fig.18(a), the refractive index has 1.58 when the ratio of the flow rate is 5. The refractive index abruptly decreases to 1.47 when the ratio of the flow rate is 11. The refractive index slightly increases to 1.48 when the ratio of the flow rate is changed from 11 to 23.

Fig.18(b) is a characteristic diagram showing the dependency of the refractive index in a range 180 SCCM to 650 SCCM of the total gas flow amount of N₂0/SiH₄. As shown in Fig.18(b), the refractive index increases as the total gas flow amount is increased, so that it changes in a range from 1.47 to 1.5.

Fig.18(c) is a characteristic diagram showing the dependency of the refractive index in a range 100 W to 300 W of the RF electric power [P_{RF]}. As shown in Fig.18(c), the refractive index has 1.54 at the RF electric power 100 W, and it abruptly decreases at the RF power of 200 W. It seldom changes like 1.47 to 1.48 over the RF power from 200 W to 300 W.

### 4) Ratio of etching rate of the film

The ratio of the etching rate of the silicon oxide film has been examined in a predetermined range of each parameter. The ratio of the etching rate is the same as the definition explained in the above (B), (ii), and 4). The results thereof are given in Figs.19(a) to (c).

Fig.19(a) is a characteristic diagram showing the dependency of the ratio of the etching rate in a range 5 to 23 of the ratio of the flow amount of N₂0/SiH₄. As shown in Fig.l9(a), the ratio of the etching rate has 19 when the ratio of the flow rate is 5. The ratio of the etching rate abruptly decreases to 7 when the ratio of the flow rate is 11. The ratio of the etching rate becomes slightly small to 6 when the ratio of the flow amount is changed from 11 to 23.

The fact that the ratio of the etching rate is large while the ratio of the flow rate is small corresponds to tendencies in Figs.16(a), 17(a) and 18(a). That is, since the SiH bonds and the NH bonds remain in the film, the porous silicon oxide film is formed. As a result, it seems that the ratio of the etching rate becomes.

Fig.19(b) is a characteristic diagram showing the dependency of the ratio of the etching rate in a range 180 SCCM to 650 SCCM of the total gas flow amount of N₂0/SiH₄. As shown in Fig.19(b), the refractive index increases as the total gas flow amount is increased, so that it changes in a range from 6 to 12.

Fig.19(c) is a characteristic diagram showing the dependency of the ratio of the etching rate in a range 100 W to 300 W of the RF electric power [P_{RF]}. As shown in Fig.19(c), the ratio of the etching rate changes in a range from 7 to 12.

As specifically explained above, in the comparison example, the value of the ratio of the etching rate was large, so that the fineness of the film was considerably inferior in contrast to the thermal oxide film.

## Claims

1. An apparatus for forming a film, comprising:
a plasma generating chamber (1) for generating plasma in a helicon mode;
a first reaction gas introducing pipe (8) for introducing a first reaction gas into said plasma generating chamber (1);
an antenna (2) arranged around said plasma generating chamber (1), for activating said first reaction gas by irradiating electromagnetic waves into said plasma generating chamber (1);
a source solenoid (5 or 6) arranged around said plasma generating chamber (1), for forming magnetic field in said plasma generating chamber (1);
a film forming chamber (7) coupled to said plasma generating chamber (1);
an exhausting port (11) for exhausting said plasma generating chamber (1) and said film forming chamber (7);
a substrate holder (12) provided in said film forming chamber (7), for holding a substrate (15) on which said film is formed; and
a second reaction gas introducing pipe (9) for introducing a second reaction gas over said substrate holder (12) and discharging said second reaction gas to a surface of said substrate (15) on said substrate holder (12).

2. The apparatus according to claim 1, wherein a high frequency power source (4) of 13.56 MHz is connected to said antenna (2).

3. The apparatus according to claim 1, wherein said second reaction gas introducing pipe (9) has a gas discharging portion (9a) composed of a ring- like pipe in which a plurality of gas discharging holes (9b) are formed.

4. The apparatus according to claim 1, wherein a high frequency power source (14) for supplying a high frequency electric power of the frequency 13.56 MHz or 100 kHz is connected to said substrate holder (12).

5. A method of forming a film, comprising the steps of:
generating plasma in a helicon mode composed of a first reaction gas by irradiating electromagnetic waves and applying a magnetic field to said first reaction gas;
activating a second reaction gas by said plasma;
biasing a substrate by a voltage; and
forming a film on said substrate by causing said first reaction gas plasmanized and said second reaction gas activated to react.

6. The method according to claim 5, wherein said second reaction gas is introduced in the downstream from where said plasma is generated so as to activate said second reaction gas after said first reaction gas plasmanized is transferred to the downward.

7. The method according to claim 5, wherein said first reaction gas is an oxygen gas, and said second reaction gas is a gas including TEOS.

8. The method according to claim 5, wherein said first reaction gas is an oxygen gas, and said second reaction gas is an SiH₄ gas.

9. The method according to claim 6, wherein said first reaction gas is an oxygen gas, and said second gas is an SiH₄ gas.

10. The method according to claim 5, wherein a frequency of said electromagnetic waves to be irradiated to said first reaction gas is 13.56 MHz.

11. The method according to claim 5, wherein a high frequency electric power of the frequency 13.56 MHz or 100 kHz is applied to said substrate in order to bias said substrate by a voltage.
